(19) Europäisches Patentamt
European Patent Office
Office européen des brevets

(11) **EP 2 494 272 B1**

(12) **EUROPÄISCHE PATENTSCHRIFT**

(45) Veröffentlichungstag und Bekanntmachung des Hinweises auf die Patenterteilung:
**01.07.2015  Patentblatt 2015/27**

(21) Anmeldenummer: **10770810.9**

(22) Anmeldetag: **25.10.2010**

(51) Int Cl.:
*F22B 1/02* [(2006.01)]       *F22B 1/04* [(2006.01)]
*B22D 11/055* [(2006.01)]    *B22D 11/124* [(2006.01)]
*B22D 11/22* [(2006.01)]      *H01L 35/30* [(2006.01)]

(86) Internationale Anmeldenummer:
**PCT/EP2010/066055**

(87) Internationale Veröffentlichungsnummer:
**WO 2011/051220 (05.05.2011 Gazette 2011/18)**

(54) **VERFAHREN ZUR ENERGIERÜCKGEWINNUNG IN HÜTTENTECHNISCHEN ANLAGEN UND HÜTTENTECHNISCHE ANLAGE AUF BASIS VON THERMOELEMENTEN**

METHOD FOR RECLAIMING ENERGY IN SMELTING SYSTEMS AND SMELTING SYSTEM BASED ON THERMOCOUPLES

PROCÉDÉ DE RÉCUPÉRATION D'ÉNERGIE DANS DES INSTALLATIONS MÉTALLURGIQUES ET INSTALLATION MÉTALLURGIQUE À BASE D'ÉLÉMENTS THERMIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.10.2009   DE 102009051095**
**02.02.2010   DE 102010006695**
**20.02.2010   DE 102010008728**
**02.09.2010   DE 102010036188**

(43) Veröffentlichungstag der Anmeldung:
**05.09.2012   Patentblatt 2012/36**

(73) Patentinhaber: **SMS Siemag AG**
**40237 Düsseldorf (DE)**

(72) Erfinder:
• **SEIDEL, Jürgen**
**57223 Kreuztal (DE)**
• **FINCK, Markus**
**40472 Düsseldorf (DE)**

(74) Vertreter: **Klüppel, Walter et al**
**Hemmerich & Kollegen**
**Patentanwälte**
**Hammerstraße 2**
**57072 Siegen (DE)**

(56) Entgegenhaltungen:
**EP-A1- 0 027 787          EP-A1- 1 965 446**
**WO-A2-2005/104156      JP-A- 58 047 506**
**JP-A- 2001 205 427       US-A- 4 059 253**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zur Energierückgewinnung in hüttentechnischen Anlagen umfassend eine Stranggießanlage und/oder einen Ofen und/oder eine Warmbandstraße durch Nutzung von Restwärme eines Anlagenteils bzw. Produkts. Des weiteren betrifft die Erfindung eine hüttentechnische Anlage.

Im Hüttenwerksbereich, d. h. in der Stahl-, Aluminium- und NE-Metallerzeugung, fallen prozessbedingt große Mengen Abwärme an, z. B. bei der Erschmelzung von Roheisen oder direkt reduziertem Eisenschwamm, bei der Erzeugung von Rohstahl ("Frischen", also im Konverterprozess) und in der komplexen Medienhandhabung (Kühlwasser). Auch die hüttentechnischen Produkte beinhalten oft eine große Wärmemenge.

Insbesondere gilt dies für Stranggießanlagen und Warmbandstraßen, insbesondere bei der Erzeugung und Verarbeitung von Brammen zu Bändern bzw. Coils, wobei die bei der Abkühlung des Gießstrangs sowie der Brammen, Knüppel und/oder Coils freiwerdende Wärmeenergie abfällt.

Bei der Abkühlung des Stahls von ca. 1.570 °C (flüssig) auf eine mittlere Temperatur von ca. 1.200 °C beim Auslauf aus der Stranggießanlage werden dem Stahl ca. 145 kWh/t Wärmeenergie entzogen. Diese Wärme geht zumeist ungenutzt an die Umgebung (Luft und Kühlwasser) verloren.

In Warmbandanlagen wird nach dem Gießen die Restwärme der Brammen bisher so genutzt, dass die Brammen entweder direkt gewalzt oder warm bzw. heiß in den Ofen eingesetzt werden. Hierdurch lässt sich viel Heizenergie sparen. Voraussetzung für den Heiß- oder Direkteinsatz sind die örtliche Nähe von Stranggießanlage und Brammenofen. Dies ist bei älteren Anlagen jedoch nicht immer gegeben. Aus Gründen der Logistik, Oberflächenprüfung, Walzprogrammplanung etc. wird nur ein Teil der Produktion direkt bzw. heiß weiterverarbeitet. Entsprechend kühlen deshalb normalerweise die Brammen nach dem Gießen in einer mit Luft durchströmten Halle ab und werden vor ihrem Weitertransport aufgestapelt. Gleiches gilt für die in den Coils nach dem Wickeln vorhandene Restwärme, die oftmals im Coillager an der Luft abkühlen.

Die Wirtschaftlichkeit einer metallurgischen Anlage hängt stark von ihrem Energieverbrauch ab. Eine Ersparnis eingesetzter Energie, aber auch die Rückgewinnung von Restwärme kann die Wirtschaftlichkeit einer Anlage verbessern.

Im komplexen Prozess der Stahlerzeugung fallen Restwärmemengen in verschiedenen Prozessschritten an. Diese charakterisieren sich einerseits über ihren Wärmeinhalt pro Zeit, also im Wärmestrom, andererseits über die Temperatur, bei der der Prozess abläuft bzw. seine Energie nutzbar aufgefangen werden kann. Gleichzeitig muss zur Nutzung der Energie eine Wärmesenke mit geringerer Temperatur zur Verfügung stehen.

Die große Bandbreite an Restwärmequellen erfordert skalierbare Aggregate, die flexibel an die anfallende Wärmemenge angepasst werden können und gleichzeitig einen hinreichenden Wirkungsgrad haben, um ihren Einsatz auch in Anwendungen bei geringerem Temperaturniveau zu ermöglichen.

Die Restwärmenutzung durch die Umwandlung von Wärme in elektrische Energie oder Nutzung der Prozesswärme wird in Industriezweigen wie Metall-, Zement- oder Glasindustrie, die sehr energieintensiv sind, zunehmend durchgeführt.

Auch im Bereich der Stahlerzeugung ist aus der WO 2008/075870 A1 bekannt, die bei der Herstellung von flüssigem Eisen durch Reduktion in einem Wirbelbettreaktor anfallende Abwärme zur Hochdruckdampferzeugung abzuführen, durch den dann beispielsweise eine Dampfturbine zur Stromerzeugung betrieben wird.

In der EP 0 044 957 B1 wird eine Anlage zur Rückführung der latenten und fühlbaren Wärme von Abgasen aus einem Kupolofen für die Gusseisenerzeugung oder einer ähnlichen Schmelzeinrichtung beschrieben, zum Zweck des Gewinnens von elektrischer und/oder thermischer Energie in Form von Dampf und/oder warmem Wasser. Die Anlage besteht aus einer Wärmeeinheit mit einem Brenner und zwei mit den Rauchgasen durchströmten Abhitzekesseln sowie bei der Erzeugung von elektrischer Energie zusätzlich einer mit Dampf aus einem Überhitzer gespeisten Turbine und einem Wechselstromgenerator.

Aus der DE 26 22 722 C3 ist eine Vorrichtung zur Abkühlung von heißen Stahlbrammen im Anschluss an den letzten Walzvorgang bekannt, in der die Stahlbrammen zwischen in parallelen Reihen angeordneten senkrechten Haltesäulen hochkant gestellt werden. Die von den Stahlbrammen abgestrahlte Wärme wird von zwischen den Haltesäulen angeordneten Kühlwänden mit Kühlwasserdurchströmten Rohrbündeln aufgenommen und zur Dampferzeugung genutzt.

Die EP 0 027 787 B1 beschreibt eine Anlage zur Gewinnung der fühlbaren Wärme von im Stranggießverfahren gegossenen Brammen in einer Kühlkammer mittels Luft, die mit einem Gebläse in direkten Kontakt mit den Brammenoberflächen gebracht wird. Die auf diese Weise erwärmte Luft dient dann außerhalb der Kühlkammer als Heizmedium, insbesondere für ein in einem thermodynamischen Kreisprozess geführtes Kreislaufmedium.

Die EP 1 965 446 A1 und die WO 2005/104156 A2 offenbaren thermoelektrische Module als solche sowie deren Herstellverfahren.

Trotz der großen Wärmemengen, die im Hüttenwerksbereich anfallen, lohnt ihre Nutzung dennoch häufig nicht. Zum einen sind die Energien in vielen Fällen zu niedrig temperiert, zum anderen erfordert ihre Nutzung auch das Vorhandensein einer "kalten Seite", da jeder Kreisprozess zur Energiegewinnung auf ein Wärmegefälle ($\Delta T = T_0 - T_u$)

angewiesen ist. Bei gegebenem Wärmestrom dQ/dt berechnet sich die nutzbare Leistung P zu P = η dQ/dt, wobei η der Wirkungsgrad des Gesamtprozesses ist.

Der Wirkungsgrad ist begrenzt durch den Carnot-Wirkungsgrad des idealen Kreisprozesses, der sich errechnet zu η = (1 - ($T_u/T_0$)). Die Temperaturen sind dabei in Kelvin einzusetzen.

Je höher die Prozesstemperatur $T_0$ ist, desto größer ist auch der Carnot-Wirkungsgrad. Der Wirkungsgrad des Kreisprozesses ist dabei im Allgemeinen ein näherungsweise konstanter Bruchteil des Carnot-Wirkungsgrades. Kreisprozesse zur Energiegewinnung können mit unterschiedlichen Aggregaten aufgebaut werden, z. B. Verdampfer, Turbine und Rückkühlung, wie die obigen Beispiele zeigen. Hierbei dient Wasser als wärmeführendes Medium.

Bestehende Lösungsansätze zur Wärmerückgewinnung in hüttentechnischen Anlagen basieren also auf klassischen Kreisprozessen, d. h. ein wärmeführendes Medium wird beispielsweise über eine Dampfturbine geleitet, die wiederum einen Generator antreibt. Das klassische Medium für diese Zwecke ist Wasser, jedoch kommen in Sonderfällen auch niedrig siedende Kohlenwasserstoffverbindungen in Frage (sog. ORC - Organic Rankine Cycle).

Der Wirkungsgrad einer solchen Lösung steigt mit der Größe der Anlage. Dies schränkt die Skalierbarkeit einer solchen Lösung ein. Eine ORC-basierte Anlage lohnt sich erst ab einer bestimmten Größe und damit ab einem bestimmten Investitionsvolumen. Im Gegensatz dazu können Thermoelemente auch bei kleineren Wärmequellen eingesetzt werden. Die nötigen Investitionskosten sind nahezu proportional zur installierten elektrischen Leistung. Der Wirkungsgrad ist nahezu größenunabhängig.

Weitere Nachteile beim Einsatz des ORC-Verfahrens sind das zusätzlich notwendige Wärmetransportmedium sowie seine Temperaturbeständigkeit (nach heutigem Stand ca. 320 °C). Zudem beinhaltet dieser Ansatz eine erhebliche Menge an Zusatzaggregaten.

Der vorliegenden Erfindung liegt die Aufgabe zugrunde, ein Verfahren und eine Vorrichtung zur Energierückgewinnung in hüttentechnischen Anlagen durch Nutzung von Restwärme eines Anlagenteils bzw. eines warmen Produkts vorzuschlagen, mit dem bzw. mit der es möglich wird, einen hinreichenden Wirkungsgrad zu erreichen, wobei die Anlage in einfacher Weise und optimal an die gegebenen Größenverhältnisse der hüttentechnischen Anlage anpassbar ist. Dabei soll eine wirtschaftliche Umsetzung möglich sein. Demgemäß soll also insbesondere ein Verfahren und eine Anlage zur effizienten Energierückgewinnung der Kühlwärme einer Stranggießanlage sowie der Restwärme von Brammen und Coils, die in einer Warmbandstraße vorhanden ist, vorgeschlagen werden.

Die Lösung dieser Aufgabe durch die Erfindung ist verfahrensgemäß dadurch gekennzeichnet, dass ein Wärmestrom von einem Anlagenteil bzw. einem warmen Produkt mit einem ersten Temperaturniveau zu einem Ort mit einem zweiten, geringeren Temperaturniveau fließen gelassen wird, wobei im Bereich zwischen den beiden Temperaturniveaus mindestens ein Thermoelement angeordnet wird, mit dem unter Nutzung des Wärmestroms unmittelbar elektrische Energie gewonnen wird.

Als Thermoelement kommt bevorzugt ein solches mit mindestens einer dotierten Halbleiterpaarung zum Einsatz. Als Thermoelement kommt weiterhin bevorzugt ein solches zur Anwendung, das mittels des PVD-Verfahrens (Physical Vapor Deposition) hergestellt wurde. Dabei ist bevorzugt eine Anzahl von Thermoelementen zu einem thermoelektrischen Generator (TEG) zusammengeschaltet.

Bevorzugt ist dabei vorgesehen, dass zunächst eine Bramme in einer Stranggießanlage gegossen wird und dass hinter der Stranggießanlage die Bramme mittels einer Trennvorrichtung, insbesondere einer Brennschneidmaschine, abgelängt wird, wobei die Bramme vor und/oder hinter der Trennvorrichtung mit Wärmedämmmitteln gegen Wärmeabfuhr geschützt wird. In diesem Falle können als Wärmedämmhaube ausgebildete Wärmedämmmittel so positioniert werden, dass sich ihre Lage der aktuellen Brammengröße und/oder den Gegebenheiten beim Ablängen der Bramme anpasst.

Die abgelängte Bramme kann dann in ein Brammenlager transportiert werden, wobei der Transport über einen Rollgang erfolgt, der zumindest teilweise von thermoelektrischen Generatoren umgeben ist. Die Bramme kann dabei so zwischen der Stranggießanlage und dem Brammenlager in Längs- oder Querrichtung transportiert und abkühlen gelassen werden, dass sie eine vorgegebene Temperatur erreicht oder nicht unterschreitet.

Das mindestens eine Segment eines thermoelektrischen Generators bzw. Thermoelement ist bevorzugt an zumindest einer Seite gekühlt. Die Seite stellt die Wärmesenke im Energierückgewinnungsprozess dar.

Eine weitere verfahrenstechnische Ausgestaltung sieht mit Vorteil vor, dass Kühlwärme an der Kaltseite des Thermoelements für einen anderen Prozess eingesetzt wird, der Wärme benötigt. Die Kühlwärme wird dabei bevorzugt zur Trocknung eines Gutes, Meerwasserentsalzung, zur Heizung einer Einrichtung oder für chemische Prozesse eingesetzt.

Die hüttentechnische Anlage umfassend eine Stranggießanlage und/oder einen Ofen und/oder eine Warmbandstraße, die einen Anlagenteil bzw. ein warmes Produkt mit einem ersten Temperaturniveau sowie einen Ort mit einem zweiten, geringeren Temperaturniveau aufweist, zeichnet sich dadurch aus, dass im Bereich zwischen dem Anlagenteil bzw. Produkt mit dem ersten Temperaturniveau und dem Ort mit dem zweiten Temperaturniveau mindestens ein Thermoelement angeordnet ist, das zur direkten Erzeugung elektrischer Energie unter Nutzung des sich aufgrund des Temperaturgradienten ergebenden Wärmestroms geeignet ist.

Das Thermoelement weist bevorzugt mindestens eine dotierte Halbleiterpaarung auf. Es weist bevorzugt einen Siliziumwafer auf, der mittels des PVD-Verfahrens (Physical Vapor Deposition) beschichtet und anschließend mechanisch bearbeitet ist. Vorzugsweise ist eine Anzahl von Thermoelementen zu einem thermoelektrischen Generator (TEG) zusammengeschaltet.

Bereits während dem Gießen in der Stranggussanlage können zwischen und/oder neben den Strangrollen Thermoelemente bzw. thermoelektrische Generatoren (TEGs) eingebaut sein.

Beim Transport der Produkte auf einem Transportweg, insbesondere einem Rollgang, an dem kein Thermoelement angeordnet ist, kann der Transportweg mit Wärmedämmmitteln versehen sein.

Alternativ kann ein Transportweg, insbesondere ein Rollgang bzw. das transportierte Produkt, mit Thermoelementen bzw. thermoelektrischen Generatoren zwecks Stromerzeugung versehen sein.

Beim Nachwärmen oder Erwärmen der Produkte (z. B. Brammen) in einem Ofen entweicht die warme Verbrennungsluft durch den Abgaskanal. Innerhalb des Abgaskanals oder/und der Rohr- bzw. Kanalwand sind Thermogeneratormodule vorgesehen, um die Abwärme in elektrische Energie umzuwandeln. Dieses System wird auch mit der Ofenluftvorwärmung kombiniert.

Die Anlage kann ein Brammen- und/oder Coillager umfassen, dessen Wandungen Thermoelemente und/oder Wärmedämmmittel aufweisen. Die Thermoelemente und/oder die Wärmedämmmittel können dabei beweglich, insbesondere schwenkbar oder translatorisch verschieblich angeordnet sein. In dem Lager können weiterhin Luftumwälzmittel, insbesondere mindestens ein Gebläse, angeordnet sein.

Das Brammen- und/oder Coillager kann auch als Warmhaltegrube ausgebildet sein.

Bevorzugt sind ferner Kühlmittel angeordnet, um mindestens eine Seite des Thermoelements zu kühlen.

Obwohl Thermoelementen im Vergleich mit Anlagen, in denen ein thermodynamischer Kreisprozess abläuft, ein völlig anderes Funktionsprinzip zugrunde liegt, ist auch ihr Wirkungsgrad durch den Carnot-Wirkungsgrad begrenzt.

Herkömmliche Thermoelemente werden seit den 1950er Jahren gebaut und eingesetzt. Sie basieren auf dem sogenannten Seebeck-Effekt, der sich technisch nutzen lässt, wenn zwei elektrische Leiter miteinander in Kontakt gebracht und mit einem Temperaturgradienten beaufschlagt werden. Dabei stellt sich eine elektrische Spannung ein. Ein kontinuierlich aufgebrachter Wärmefluss erzeugt dann elektrische Energie.

Obwohl Thermoelemente schon lange bekannt sind, haben sie noch keine breite Anwendung in der Elektrizitätserzeugung erfahren. Hintergrund sind ihr bei herkömmlicher Bauweise relativ kleiner Wirkungsgrad sowie die kostenintensive Fertigung.

In letzter Zeit hat die Entwicklung von Thermoelementen entscheidende Fortschritte gemacht, die ihre technische Anwendbarkeit bei weitem attraktiver erscheinen lassen. Thermoelemente der neuesten Generation werden auf Basis von dotierten Halbleiterpaarungen erstellt. Die Produktionsprozesse sind wesentlich verbessert worden und basieren auf effizienten Verfahren, wie sie aus der Massenproduktion von Computerchips bekannt sind.

Es kommen Siliziumwafer zum Einsatz, die mit Hilfe des PVD-Verfahrens (Physical Vapor Deposition) beschichtet und anschließend mechanisch bearbeitet werden. Die nach diesem Verfahren hergestellten Elemente erreichen eine vielfach bessere Leistungsausbeute bei günstigen Herstellpreisen als bislang marktübliche Thermoelemente.

Zur Energieerzeugung im technisch relevanten Maßstab wird eine Vielzahl von Thermoelementen zu einem thermoelektrischen Generator (TEG) zusammengeschaltet.

Einen ausreichenden nutzbaren Wirkungsgrad vorausgesetzt, bieten Thermoelemente eine Lösung für das oben erläuterte Größenproblem. Thermoelemente lassen sich problemlos zu großen Einheiten zusammenschalten, ohne dass dies einen negativen Einfluss auf den Wirkungsgrad hat. In vorteilhafter Weise lassen sich somit die zu erstellenden Aggregate genau auf den anfallenden zu nutzenden Wärmestrom im jeweiligen Prozessschritt abstimmen.

Eine Lösung gemäß dem Stand der Technik auf der Basis von Dampfturbinen oder allgemein eines Rankine-Kreisprozesses bietet indes deutlich weniger Flexibilität. Hinzu kommt das Problem des wärmeführenden Mediums sowie der beweglichen Teile der Wärmerückgewinnungsanlage. Thermoelemente sind dagegen in der Lage, elektrische Energie auf direktem Wege zu gewinnen, ohne Zusatzaggregate zu benötigen. Der Verzicht auf ein wärmeführendes Medium erhöht auch prinzipiell den Wirkungsgrad, da der Carnot-Wirkungsgrad im Allgemeinen höher sein kann.

Demgemäß wird es durch die vorgeschlagene Lösung möglich, eine auf die jeweilige Anwendung genau zugeschnittene Anlage zu konstruieren, die den Einsatz von Thermoelementen in einer hüttentechnischen Anlage ermöglichen und deren Vorteile voll zum Tragen zu bringen. Es wird ermöglicht, einen Wärmestrom effizient zu nutzen und auf die Thermoelemente zu übertragen. Ebenso wichtig ist eine effiziente Rückkühlung, insbesondere unter Ausnutzung bereits vorhandener Anlagenkomponenten (z. B. eines Kühlkreislaufs). Abhängig vom konkreten Einsatzort können solche Aggregate konstruktiv sehr unterschiedlich aufgebaut sein. Die Konstruktion kann dazu skalierbar ausgeführt werden. Eine modulare Bauweise bietet sich an.

Gemäß einer bevorzugten Ausgestaltung der Erfindung wird der Gießstrang bzw. die Bramme in Richtung Walzstraße oder in ein Brammenlager und danach in ein Coillager transportiert, wobei während des Gießens und/oder des Transports Wärme entzogen wird. Die Brammen oder Coils können dabei teilweise übereinander auf besonderen vorbereiteten und mit TEG-Modulen ausgebildeten Speicherplätzen für kurze Zeit oder mehrere Stunden bzw. Tage abgelegt werden, wobei in diesem Transportzeitraum dem Gießstrang und/oder der Bramme und/oder im Lagerzeitraum die Restwärme an TEG-Modulen zur Stromerzeugung abgegeben wird. Diese Anlagebereiche zeichnen sich durch eine kontinuierliche Bereitstellung der Wärme und eine hohe Energiedichte und damit hoher Stromerzeugungseffizienz aus.

Mit den erwähnten TEG-Elementen wird direkt Strom erzeugt. Die TEG-Elemente sind insofern besonders geeignet, als dass die Energieeffizienz und die Produktionstechniken in letzter Zeit gegenüber traditionell hergestellten Elementen erheblich verbessert wurden. Die erzielbaren Wirkungsgrade sind dabei durchaus vergleichbar mit denen konventioneller Techniken (z. B. ORC - Organic Rankine cycle, d. h. Dampfturbinenprozess mit niedrig siedendem organischen Medium) - in hier relevanten Temperaturbereich in Hüttenanlagen ca. 10% - 15%. TEG-Elemente benötigen zwingend jedoch keine externen Zusatzaggregate, da der Strom direkt in unmittelbarer Nähe der Wärmequelle erzeugt wird, d. h. es entfallen die Turbine, der mechanische Generator sowie die Verrohrung für die Wärmetransportmedien. Lediglich für die Kaltseite der thermoelektrischen Generatoren kann statt Luft eine Kühlung mit einem flüssigen Medium erfolgen.

Es ist ebenso möglich, dass dem Strang während des Gießens bereits Wärme entzogen und diese Wärme an die TEG-Module zur Stromerzeugung abgeführt wird. Hierfür sind TEG-Module bevorzugt zwischen den Strangrollen vorgesehen.

Nach dem Trennen bzw. Schneiden der Brammen auf Länge werden die Brammen von der Stranggießanlage möglichst schnell in das Brammenlager bzw. die Coils nach dem Wickeln in das Coillager transportiert und dort auf die mit TEG-Modulen ausgebildeten Speicherplätze abgelegt. Auch bereits während ihres Transports zum Brammenlager bzw. Coillager kann den Brammen bzw. Coils eine Teilmenge ihrer Restwärme entzogen werden, wozu die zu den Speicherplätzen führenden Transportmittel wärmegedämmt ausgeführt oder mit TEG-Modulen ausgebildet sein können. Der Transport der Brammen kann in Längsrichtung in einer Art inversem Rollenherdofen oder in Querrichtung in einer Art inversem Stoß- oder Hubbalkenofen erfolgen. Bei langsamer Transportgeschwindigkeit und langer Transportstrecke stellt diese Bauform einen Teil des Brammenlagers mit TEG-Modulen zur Energierückgewinnung bzw. Stromerzeugung dar.

Die Brammenlager bzw. Coillager können mit Vorteil als Hochregale ausgebildet sein, in die die Brammen bzw. Coils flach mit beispielsweise einem Stapler seitlich in die Speicherplätze eingeschoben werden. Die Brammen bzw. Coils liegen dabei auf Tragschienen auf. Wände, Decken und Bodenkonstruktionen sind mit TEG-Modulen ausgekleidet. Alternativ und besonders vorteilhaft sind die TEG-Module vor den tragenden Wänden positioniert, damit deren Zugänglichkeit und einfache Austauschbarkeit im Wartungsfall gegeben ist. In einer anderen Ausführungsform werden die Brammen gekippt und hochkant zwischen TEG-Modulen gelagert, wobei die Brammenlager mit Führungsstreben und/oder seitlichen Rollen ausgebildet sind, um ein Umkippen der Brammen zu verhindern. In einem derartigen Brammenlager liegen die Brammen nur an wenigen Stellen auf, beispielsweise auf Rollen.

Damit Brammen bzw. Coils mit möglichst hoher Temperatur auf den Speicherplätzen liegen, kann ein entsprechender sinnvoller/optimaler Austausch der Brammen bzw. Coils innerhalb des Brammen- bzw. Coillagers durchgeführt werden.

Um einen ungehinderten Transport der Brammen bzw. Coils in und aus diesen Speicherplätzen durchführen zu können, sind die oberhalb der Brammen bzw. Coils angeordneten TEG-Module dabei bevorzugt schwenkbar oder verfahrbar angeordnet. Alternativ sind die Speicherplätze mit schwenkbaren oder verfahrbaren wärmeisolierten Dämmhauben mit oder ohne integrierte TEG-Modulen versehen.

Auch die Erzeugung einer turbulenten Luftströmung im Wärmetauscherbereich bzw. innerhalb der Speicherplätze mit beispielsweise Gebläse bzw. Ventilatoren verkürzt die Abkühlzeit. Hierbei muss jedoch die maximal zulässige Abkühlgeschwindigkeit der Brammen bzw. Coils berücksichtigt werden, um keine Qualitätsminderung herbeizuführen.

Eine typische bevorzugte Ausführungsform für die Anordnung mehrerer Speicherplätze nebeneinander ist in Form einer Warmhaltegrube möglich. Die Brammen liegen in Längsrichtung auf Tragbalken auf. Durch verschiebbare Deckenplatten können die Brammenstapel darunter erstellt oder die Brammen nach der Abkühlung hier einzeln entnommen werden. Alternativ sind die Deckenplatten auch für jeden Speicherplatz einzeln hochschwenkbar. Am Boden, an der Wand und optional auch an der Decke sowie zwischen den Brammenstapeln sind TEG-Module angeordnet. Statt über erzwungene Konvektion die Energie an die Umgebung abzuleiten, wird die Energie gezielt an diese TEG-Module abgegeben und Strom erzeugt.

Die typischen bevorzugten Verfahrensschritte beim Brammentransport und bei der Brammenspeicherung mit einem Brammenwärme-Rückgewinnungssystem laufen wie folgt ab:

    a) Gießen der Bramme.

    b) Trennen der Bramme hinter der Stranggießanlage auf geforderte Länge (optional auch im Bereich des Brammenlagers) und unter Verwendung einer Wärmedämmung vor und im Bereich der Brennmaschine. Dabei werden die Dämmhauben im Bereich der Brennschneidmaschine schrittweise abhängig von der Position der Brenner hoch geschwenkt und wieder abgesenkt, um Wärmeverlust in dem Bereich zwischen der Stranggießanlage und Brennschneidanlage und innerhalb der Brennschneidanlage zu minimieren. Zwischen den Rollgangsrollen sind in den möglichen Bereichen können ebenfalls Dämmkassetten eingebaut sein.

c) Transport der Bramme in das Brammenlager auf einem mit TEG-Modulen versehenen Rollgang zur Energierückgewinnung mit z. B. Gießgeschwindigkeit oder optional auf einem wärmegedämmten Rollgang mit vorzugsweise erhöhter Transportgeschwindigkeit.

d) Fahren der Bramme auf eine Abhebe- oder Abschiebeposition mit Gießgeschwindigkeit oder optional mit erhöhter Transportgeschwindigkeit.

Der Transport in Schritt c) und d) wird zeitlich bevorzugt so gesteuert, dass eine notwendige Mindesttemperatur der Bramme von z. B. 800 °C zum Einlagern nicht unterschritten wird.

e) Ist die Abhebeposition mit Wärmedämmhauben versehen, so werden diese hochgeklappt.

f) Schneller Transport der Bramme auf einen Wärmetauscherplatz. Vorzugsweise wird die Bramme in eine mit TEG-Modulen umgebenen Position (z. B. Grube) gestapelt bzw. transportiert. Beim Stapeln der Brammen wird nur kurzzeitig der Wärmerückgewinnungsraum zum Befüllen mit Brammen geöffnet.

g) Langsame Abkühlung der Brammen auf dem mit TEG-Modulen ausgeführten Platz, bei der die Wärmeenergie aufgefangen wird.

h) Nach Ablauf einer vorgegebenen Zeit oder Erreichen einer Brammenstapeltemperatur an einer definierten Referenzstelle wird der Brammenstapel wieder aufgelöst.

Vorzugsweise überwacht und steuert ein Prozessmodell den Abkühlprozess, wobei insbesondere ausgehend von einer gemessenen oder gerechneten Strang- bzw. Brammentemperatur die Abkühlung der Bramme abhängig von den Umgebungsbedingungen berechnet wird. Je länger die Bramme im Speicherplatz zur Wärmeabgabe verweilt, desto besser ist die energetische Ausnutzung. So verliert eine Einzelbramme beispielsweise 600 °C in 5 Stunden. Ist die Brammentonnage höher als der Durchsatz, der sich aus der Summe aller TEG-Modul-Plätze ergibt, verkürzt ein Prozessmodell die Lagerzeit entsprechend.

Gleichzeitig kombiniert das Prozessmodell den Einsatz der TEG-Modulplätze in sinnvoller Weise mit dem Lager- und Transportsystem, um beispielsweise die Brammen bzw. Coils geordnet im Lager abzustellen oder zu legen und bei Bedarf selektiv zur Weiterverarbeitung wieder herauszuholen. Ein Prozessmodell zur Steuerung anderer Prozessabläufe (Pumpen für das Kühlmedium, Produktgeschwindigkeit, etc. sind analog vorgesehen, werden jedoch nicht weiter beschrieben).

Die TEG-Module sind einseitig gekühlt. Als Kühlmedium für die TEG-Module wird vorzugsweise Wasser eingesetzt. Es können jedoch auch je nach Randbedingungen mineralisches oder synthetisches Thermoöl oder Gas (Luft, Stickstoff, Rauchgas etc.) verwendet werden.

Je nach Temperaturniveau des Kühlmediums kann es vorteilhafterweise auch für andere Prozesse wie Trocknungsanlagen, Fernheizung, chemische Prozesse, Meerwasserentsalzung etc. benutzt werden und so den Gesamtwirkungsgrad der Wärmerückgewinnungseinrichtung erhöhen. Eine Verschwendung oder Abgabe an Kühltürme würde dann entfallen.

Die beschriebene Technologie ist nicht nur auf konventionelle Warmbandanlagen oder CSP-Anlagen mit Dickbrammen oder Dünnbrammen und deren Coils beschränkt, sondern kann auch in gleicher Weise bei der Block-, Knüppel-, Träger- oder Rundstahlerzeugung etc. angewendet werden. Auch bei Nichteisen-Warmanlagen (Bandanlagen etc.) kann diese Technologie vorteilhaft sein.

Die TEG-Module können zur Energierückgewinnung für sich eingesetzt oder geeignet und vorteilhaft mit anderen Energierückgewinnungstechnologien, die vorzugsweise mit einer ORC-Anlage oder Kalina-Anlage (Kreisprozeß) ausgeführt sind, kombiniert werden. Beispielsweise werden die TEG-Module bei hohen Temperaturen betrieben, die mit einem Kühlmedium (z. B. Thermoöl) von ca. 300 °C gekühlt werden. Diese Energie (bzw. warmes Kühlmedium) wird anschließend an einer ORC-Anlage oder Kalina-Anlage zur Stromerzeugung weiter genutzt. Auch eine umgekehrte Anordnung ist denkbar, so dass zunächst die Hochtemperaturabwärme von z. B. einer ORC-Anlage aufgenommen wird und der Kondensatorwärmetauscher der z. B. ORC-Anlage die Niedertemperaturwärme an TEG-Module abgibt.

Beide Einrichtungen (Wärmetauscher zum Betreiben einer ORC-Anlage und thermoelektrische Generatoren) können auch örtlich hintereinander angeordnet sein.

In den Zeichnungen sind Ausführungsbeispiele der Erfindung dargestellt.

Es zeigen:

Fig. 1    schematisch in perspektivischer Ansicht zwei Knüppel, deren Wärmeenergie durch einen thermoelektrischen Generator in elektrische Energie umgewandelt wird,

Fig. 2    eine Seitenansicht einer Stranggießanlage mit Thermoelektrischen Generatoren (TEG-Einheiten),

Fig. 3a    in der Vorderansicht und

Fig. 3b    in der Seitenansicht einen Ausschnitt eines Strangsegments der Stranggießanlage mit TEG-Modulen zwischen den Segmentrollen der Anlage,

Fig. 4a    in der Vorderansicht und

Fig. 4b    in der Seitenansicht eine alternative Ausführungsform mit TEG-Modulen im Bereich einer Stranggießanlage,

Fig. 5    in der Draufsicht ein Brammenlager mit TEG-Modulen im Bereich der Brammenspeicherplätze,

Fig. 6    in der Seitenansicht ein Rollgang mit TEG-Modulen,

Fig. 7    in der Seitenansicht einen Brammenspeicherplatz mit feststehenden und schwenkbaren oberen TEG-Modulen,

Fig. 8a    in der Draufsicht und

Fig. 8b    in der Seitenansicht eine Anordnung von TEG-Modulen in einer Warmhaltegrube,

Fig. 9    in der Seitenansicht eine alternative Anordnung von TEG-Modulen im Bereich einer Warmhaltegrube,

Fig. 10a    in der Vorderansicht und

Fig. 10b    in der Seitenansicht ein Brammen-Hochregallager mit TEG-Modulen,

Fig. 11a    in der Draufsicht und

Fig. 11b    in der Vorderansicht ein Hochkant-Brammenlager mit TEG-Modulen,

Fig. 12    in der Draufsicht ein Coillager mit TEG-Modulen im Bereich der Coilspeicherplätze,

Fig. 13a    in der Vorderansicht und

Fig. 13b    in der Seitenansicht ein Coil-Hochregallager mit TEG-Modulen und

Fig. 14    schematisch ein Prozessmodell.

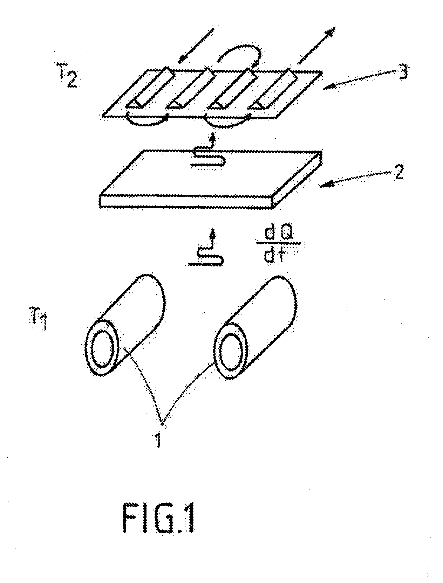

Aus der Vielzahl möglicher Anwendungen wird beispielhaft in Fig. 1 eine Vorrichtung betrachtet, die die Abwärme eines gegossenen Rundknüppels auf einem Wendekühlbett nutzbar macht.

Im Hüttenwerksbereich fallen in vielen Prozessschritten Abwärmemengen an, z. B. im Schmelz- oder Gießbetrieb in Konvertern, Elektroöfen, Stranggießanlagen, Adjustagen, aber auch beim Umformen (Warmwalzstraße, Haspel) oder der Bandbehandlung (Glühlinien).

Die ein Stahlwerk charakterisierenden Wärmequellen (z. B. Electrical Arch Furnace - EAF, Hubbalken- oder Stoßofen), die zu Ihrer Kühlung immer auch an eine Wärmesenke angeschlossen werden müssen (z. B. an einen geschlossenen Kühlwasserkreislauf), erzeugen ein bis jetzt nicht genutztes Wärmegefälle. Es ist dieser bisher ungenutzte Abwärmestrom, der bei gekühlten Stahl- und Hüttenwerksprozessen immer existiert, der vorliegend und erfindungsgemäß durch den Einsatz von thermoelektrischen Generatoren (TEG) nutzbare Energie generiert. Durch den Einbau von thermoelektrischen Generatoren zwischen die Wärmequelle und die Wärmesenke wird aufgrund der unterschiedlichen Temperaturniveaus elektrische Energie erzeugt.

Die Wärmequellen unterscheiden sich sowohl durch den nutzbaren Wärmestrom dQ/dt als auch durch die Prozesstemperatur $T_0$. Idealerweise wird der thermoelektrische Generator möglichst nahe an der Wärmequelle platziert, um einen möglichst hohen Carnot-Wirkungsgrad zu erzielen.

Eine mögliche Anwendung von thermoelektrischen Generatoren im Stahlwerk besteht darin, die Abwärme eines gegossenen Halbzeugs wie einem Knüppel 1 zu nutzen. Dieser weist eine obere Prozesstemperatur $T_1$ auf.

Unmittelbar nach dem Abguss kühlen die Knüppel 1 z. B. auf einem Wendekühlbett ab. Dabei wird ihre Wärmeenergie im Normalfall ungenutzt in die Umgebung abgestrahlt. Der dabei durch Strahlung abgegebene Wärmestrom dQ/dt berechnet sich für einen technischen Strahler zu

$$dQ/dt \ = \ \sigma \ \varepsilon \ A \ T_1^4$$

Hierbei ist

T die Temperatur in Kelvin,
$\sigma$ die Boltzmann-Konstante,
$\varepsilon$ der Emissionskoeffizient und
A die Knüppeloberfläche.

Um den abgeführten Wärmestrom zu nutzen, wird ein thermoelektrischer Generator in Form eines Panels über das Kühlbett platziert. Figur 1 zeigt zwei heiße Knüppel 1, oberhalb derer ein flächig ausgebildetes Thermoelement 2 in Form eines thermoelektrischen Generators angeordnet ist. Oberhalb des Thermoelements 2 wiederum ist eine Wasserkühlung 3 angeordnet.

Nur ein Bruchteil dieses Wärmestroms wird auf das Thermoelement 2 abgestrahlt. Dieser Bruchteil kann über einen Formfaktor berücksichtigt werden. Da sich auch die Unterseite des Thermoelements 2 aufheizt und seinerseits Strahlung emittiert, ergibt sich der vom Thermoelement 2 empfangene Nettowärmestrom als Differenz des Strahlungswärmestroms vom Knüppel 1 auf das Thermoelement 2 abzüglich des rückgestrahlten Wärmestroms vom Thermoelement 2 auf den Knüppel 1.

Diese Leistung steht dem Thermoelement 2 grundsätzlich zur Umwandlung in elektrische Energie zur Verfügung.

Die Energiebilanz am Thermoelement 2 selber muss den vom Thermoelement 2 in Richtung Wasserkühlung 3 abgegebenen Wärmestrom berücksichtigen. Wie bereits oben erwähnt wurde, kann nur ein Bruchteil des eingehenden Wärmestroms genutzt werden. Dieser Bruchteil entspricht dem Wirkungsgrad $\eta$.

Moderne, dotierte Halbleitermaterialien erreichen ca. 40% des Carnot-Wirkungsgrads $\eta_C$. Durch Wärmeleitung innerhalb des thermoelektrischen Generators 2 erfolgt darüber hinaus ein Wärmestrom durch die einzelnen Thermoelemente.

Bei gegebener Knüppeltemperatur $T_1$ und gegebener mittlerer Kühlwassertemperatur $T_2$ kann aufgrund der thermodynamischen Beziehungen errechnet werden, dass sich bei üblichen Zahlenwerten sowohl für die Knüppeltemperatur als auch für die Wassertemperatur eine nutzbare elektrische Leistung von ca. 2.000 W pro Knüppel bei einem etwaigen Wirkungsgrad von $\eta$ = 10% ergibt.

Insgesamt kann gesagt werden, dass der Einsatz moderner Thermoelemente für die Energierückgewinnung in einem Stahlwerk einige wesentliche Vorteile erbringt. Dabei sind insbesondere die große Einsatzbreite und die hohe Zuverlässigkeit zu nennen.

Durch die Weiterentwicklung der Thermoelemente bezüglich Materialeinsatz und Fertigungsverfahren in jüngerer Zeit können Wirkungsgrade erreicht werden, die die Wirtschaftlichkeit der Anlage deutlich verbessern. Weiterhin ist der Einsatz thermoelektrischer Generatoren bereits bei einem relativ geringen Investitionsapparativen Aufwand möglich.

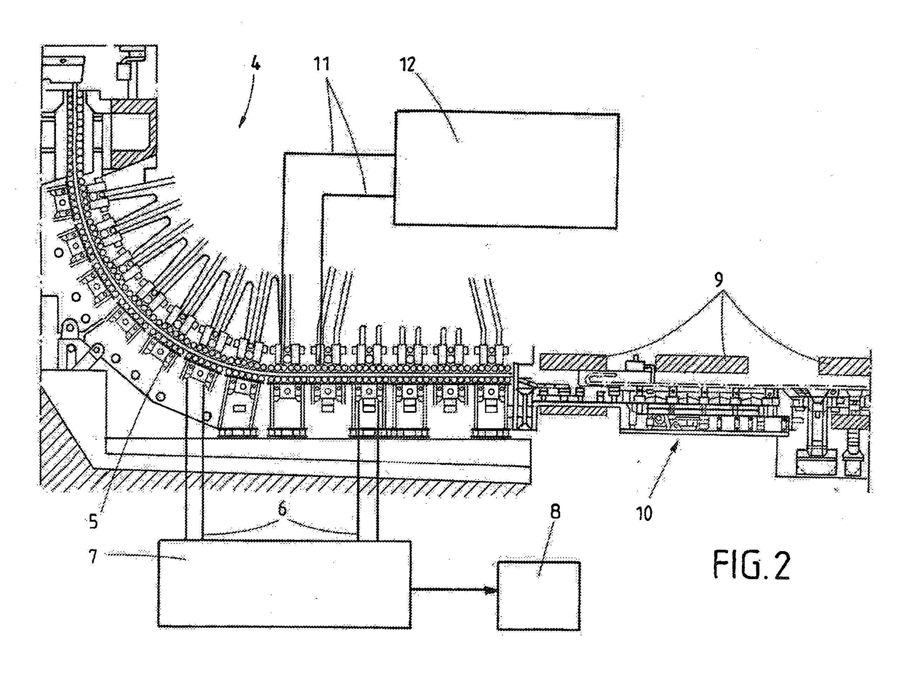

In Figur 2 ist eine Stranggießanlage 4 in der Seitenansicht dargestellt. Während des Gießprozesses gibt der Strang Wärme an die Strangrollen oder Umgebung ab. Die zwischen den Strangrollen abgegebene Wärme wird an TEG-Module 5 abgegeben. Hierzu sind die TEG-Module 5 zwischen den Strangrollen angeordnet. Die TEG-Module 5 geben den erzeugten Strom über wärmegedämmte, feuchtigkeitsgeschützte Kabel 6 an Spannungswandler bzw. Wechselrichter 7 ab, die nach der Anpassung den Strom in das Netz 8 einspeisen. Die genannten Einrichtungen sind in Figur 2 nur schematisch dargestellt. Weiterhin ist in dieser Figur auch der Bereich hinter der Stranggießanlage 4 zu sehen, der zum Teil - wie dargestellt - zur Vermeidung von Wärmeverlusten mit Rollgangsabdeckungen 9 versehen ist. Hinter der Stranggießanlage 4 befindet sich auch eine Brennschneidanlage 10 zum Ablängen von Brammen. Die TEG-Module sind gekühlt. Hierzu sind Kühlwasserleitungen 11 vorhanden, die zu einer Kühlung 12 führen (insbesondere zu einem Kühlturm).

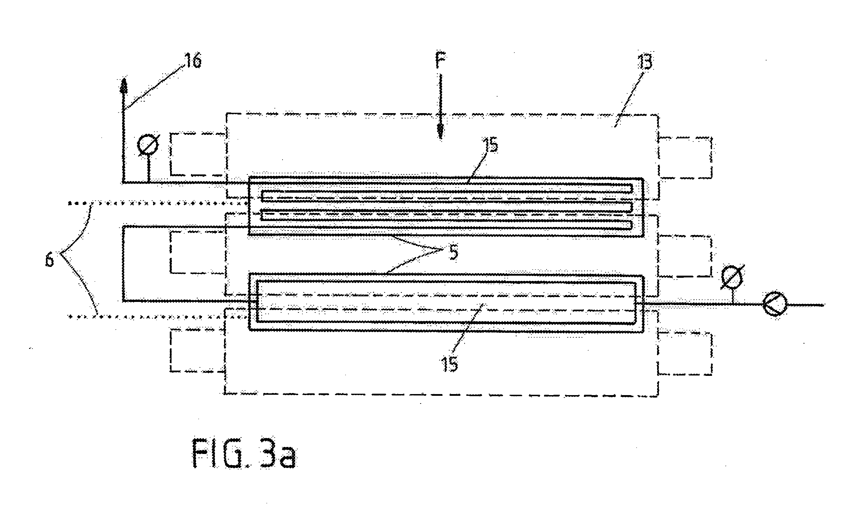

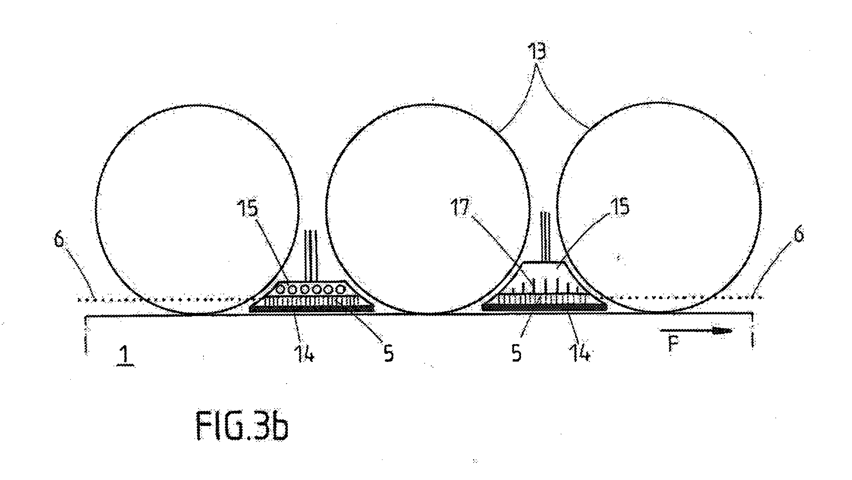

Details dieser Ausführungsform, die Wärme des Gießstrangs aufzunehmen und zwecks Energierückgewinnung über TEG-Module an eine Stromerzeugungsanlage weiterzuleiten, sind in den Figuren 3a und 3b in einer Vorderansicht und Seitenansicht dargestellt. Die Figuren zeigen nur einen Ausschnitt der Stranggießanlage bestehend aus drei Segmentrollen 13.

In dem dargestellten Beispiel wird die abgestrahlte Wärme des Gießstrangs 1 zunächst einer Wärmetauscherplatte 14 zugeführt. Diese stellt die Warmseite des TEG-Moduls 5 dar. Über Wärmeleitung wird die Wärme an die plattenförmig gestalteten TEG-Module 5 abgegeben. Auf der anderen Seite des TEG-Moduls 5 ist die Kühlung 15 angeordnet. Als Kühlung kann das Wasser der ohnehin vorhandenen Strangschalenkühlung verwendet werden. Über Kühlleitungen 16 wird das Kühlmedium nach außen geführt. Durch Anlegen dieser Temperaturdifferenz entsteht in dem TEG-Modul 5 elektrischer Strom, der über wasser-, dampf- und hitzebeständige Kabel 6 nach außen geführt wird. Detail, wie elektrische Isolation, Schutz des TEG-Moduls gegen Wasser und Dampf, sind in den Figuren nicht dargestellt. Als Kühlung 15 kann ein Plattenwärmetauscher verwendet werden, der mehrere Bohrungen hat, durch den schlangenförmig ein Kühlmedium (z. B. Wasser) fließt; Es kann auch eine Kühlkammer vorgesehen sein, die bevorzugt mit Kühlrippen 17 ausgeführt ist. Die seitlichen Befestigungen der TEG-Module 5 mit den dazugehörigen Anbauteilen sind nicht dargestellt.

Sollte alternativ oder gleichzeitig eine Strangaußenkühlung (nicht dargestellt) notwendig sein, so kann auch ein kombinierter oder alternativer Einsatz einer vorhandenen Sprühkühlung zusammen mit den gegen Feuchtigkeit geschützten TEG-Modulen 5 durchgeführt werden, wenn es aus metallurgischen Gründen zur Beeinflussung der Brammentemperatur notwendig ist.

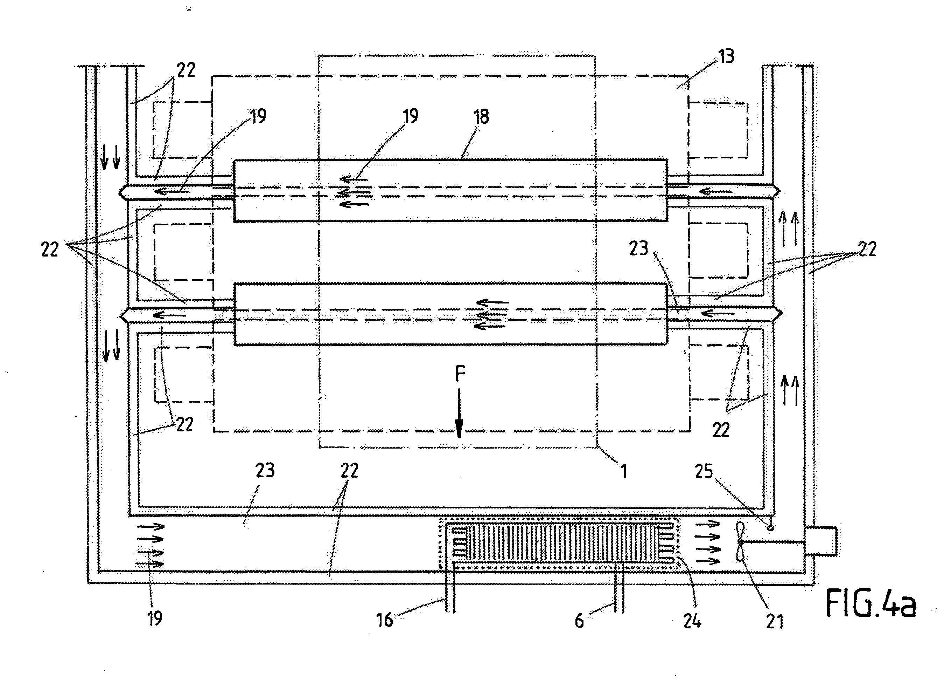

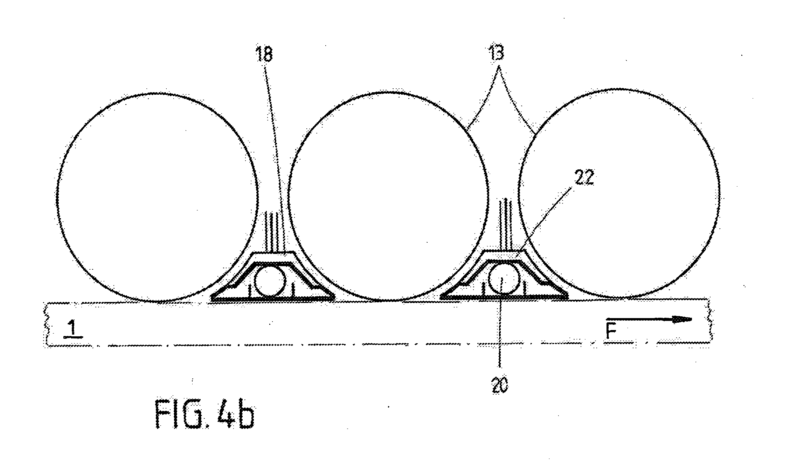

Eine weitere alternative konstruktive Ausführungsform, die Wärme des Gießstrangs aufzunehmen, ist in Fig. 4a in der Vorderansicht und in Fig. 4b in der Seitenansicht dargestellt. Die Figuren zeigen einen kleinen Ausschnitt einer Stranggießanlagenhälfte, bestehend aus drei Segmentrollen 13, die in Fig. 4a gestrichelt dargestellt sind, sowie den stichpunktiert angedeuteten Gießstrang 1. Zwischen den Segmentrollen 13 sind hier Wärmetauscher 18 eingesetzt, durch die hier ein gasförmiges Medium 19 (z. B. Luft) geleitet wird. Die abgegebene Strahlungswärme des Gießstrangs 1 wird an die Wärmetauscherplatte des Gaskanals abgegeben und von dem gasförmigen Medium 19 aufgenommen. Rippen 20 und Turbulenzbleche im Gaskanal erhöhen den konvektiven Wärmeübergang. Die den Brammen abgewandte Seite des Wärmetauschers 18 ist hier wärmegedämmt ausgeführt. Diese Dämmkassette vermindert die Wärmeverluste. Mit Hilfe eines oder mehrerer Gebläse 21 wird das gasförmige Medium von den Wärmetauschern über Gastransportleitungen zu einem oder mehreren TEG-Modulen außerhalb bzw. neben der Stranggießanlage befördert. Diese Gastransportleitungen sind hier als Ringleitungen ausgebildet und mit Wärmeisolierungen 22 versehen.

Im Wärmetauscherkanal 23 befindet sich eine Wärmetauschereinheit 24, bestehend aus dem Heißluftkanal, dem TEG-Modul und Kühlkanälen für die Wasserkühlung, die schichtweise aufgebaut sind.

Die Temperatur des gasförmigen Mediums 19 hinter der Wärmetauschereinheit (TEG-Moduleinheit) 24 wird abhängig von der gewünschten Strangkühlung sowie den Bedingungen an der Stromerzeugungsanlage oder anderer Zielvorgaben eingestellt. Als Stellglied wird der Volumenstrom des Gebläses 21 verwendet. Die Temperatur der Luft 19 wird mit einem Temperaturfühler 25 gemessen.

Die TEG-Einheit nimmt die Wärme des gasförmigen Mediums 19 auf. Die Wärmetauschereinheit 24 besteht, wie gesagt, aus Heißluftkanälen, durch die die Luft 19 strömt, sowie aus TEG-Modulen und Kühlkanälen. Diese Bauteile sind schichtweise innerhalb des Rohrs aufgebaut, so dass jeweils zwischen den TEG-Modulen eine Temperaturdifferenz entsteht und so effizient Strom erzeugt wird. Alternativ kann auch in dem Rohr mit Innenrippen an der Rohrwand eine Vielzahl von TEG-Modulen befestigt sein und außen die Kühlung der TEG-Module erfolgen.

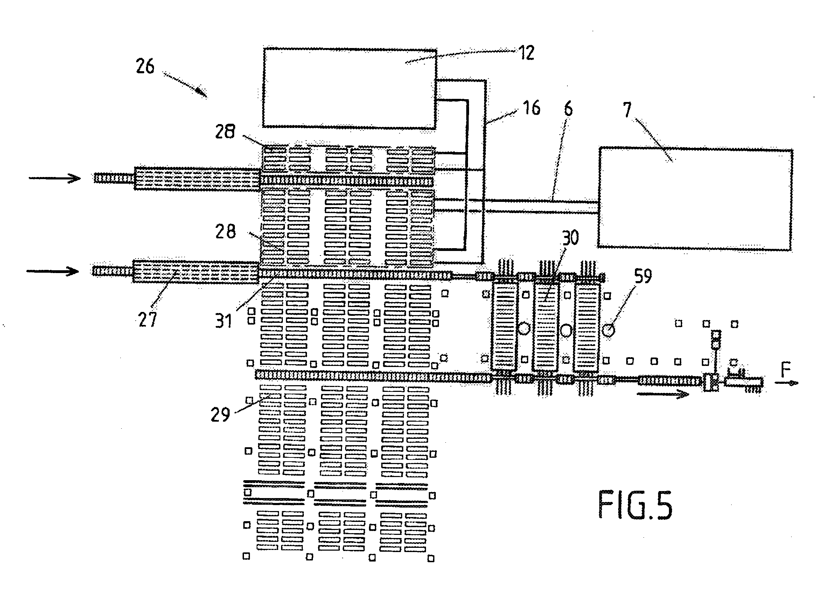

In der Figur 5 ist ein Brammenlager 26 in der Draufsicht dargestellt. Von der Stranggießanlage werden die Brammen über wärmegedämmte oder mit TEG-Modulen ausgebildete Zuführrollgänge 27 in das Brammenlager 26 transportiert. Im Brammenlager 26 sind optional ein Teil der Lagerplätze als Speicherplätze mit TEG-Modulen 28 ausgebildet, während die restlichen Lagerplätze übliche Lagerplätze 29 sind. Je nach der noch vorhandenen Brammentemperatur und dem Kühlfortschritt findet auch hier durch ein Prozessmodell ein gesteuerter Austausch der Brammen zwischen den normalen Lagerplätzen und den Speicherplätzen statt. Die auf den üblichen Lagerplätzen und die auf den Speicherplätzen abgekühlten Brammen werden dann zur weiteren Fertigung aus dem Brammenlager 26 über das Prozessmodell gesteuert abgezogen und über Wärmeöfen 30 in Transportrichtung F zur Walzstraße gefördert. Das Brammensortier- und Brammenplanungsmodell und das Prozessmodell zur Optimierung des Energieertrags sind miteinander gekoppelt. Die in den Speicherplätzen erzeugte Energie wird nach außen abgeführt und als Strom in das Netz eingespeist. Der weitere schematische Aufbau ist ähnlich, wie in Fig. 2 erläutert.

In Fig. 5 sind auch die Wärmeöfen 30 mit den dazugehörigen Abgaskanälen 59 dargestellt. Innerhalb der Abgaskanäle oder/und Rohrwandungen sind zwecks Energierückgewinnung Thermogeneratormodule vorgesehen (Details nicht gezeigt). Die Thermogeneratormodule innerhalb der Abgaskanäle sind analog aufgebaut, wie die Wärmetauschereinheit 24.

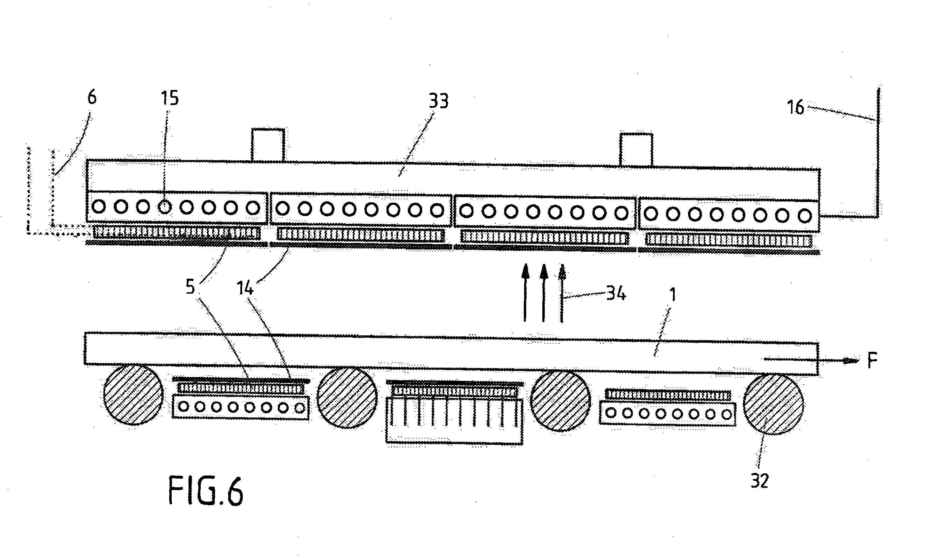

Details zur Wärmerückgewinnung während des Transports der Bramme auf einem Rollgang 31 mit Rollgangsrollen 32 sind mit verschiedenen Alternativen in Figur 6 in der Seitenansicht dargestellt. Zwischen den Rollgangsrollen 32 und entlang des Rollgangs 31 sind TEG-Module 5 angeordnet. Die TEG-Module auf der Oberseite können in einer Halteeinrichtung 33 integriert sein. Das Prinzip der Stromerzeugung infolge zugeführter Strahlungswärme und Abgabe an ein Kühlmedium entspricht hier den zuvor erwähnten Ausführungen. Auf der Unterseite wurden die Ausführungsformen etwas variiert, um die verschiedenen Möglichkeiten aufzuzeigen. Insbesondere die Kühlung 15 (Kühleinheit) kann aus einer Platte mit Bohrungen (unten links in Fig. 6) oder aus einer Kühlkammer, vorzugsweise mit Rippen, bestehen (unten Mitte in Fig. 6). Als Kühlmedium kommt Wasser oder Luft in Frage. Das TEG-Modul 5 kann auf der den Brammen zugewandten Seite mit einer Wärmetauscherplatte 14 oder selbsttragend (ohne Wärmetauscherplatte) ausgeführt sein (unten rechts in Fig. 6).

Bei längerer Bauform des Rollgangs mit kombinierten TEG-Modulen 5 nach Figur 6 sind Lücken zwischen den Einheiten vorgesehen, damit die Brammen 1 aus logistischen Gründen bzw. zur Walzprogrammplanung etc. aus der Wärmerückgewinnungslinie entnommen (abgeschoben, herausgehoben) werden können.

Die Strahlungswärme und Konvektion ist mit 34 bezeichnet.

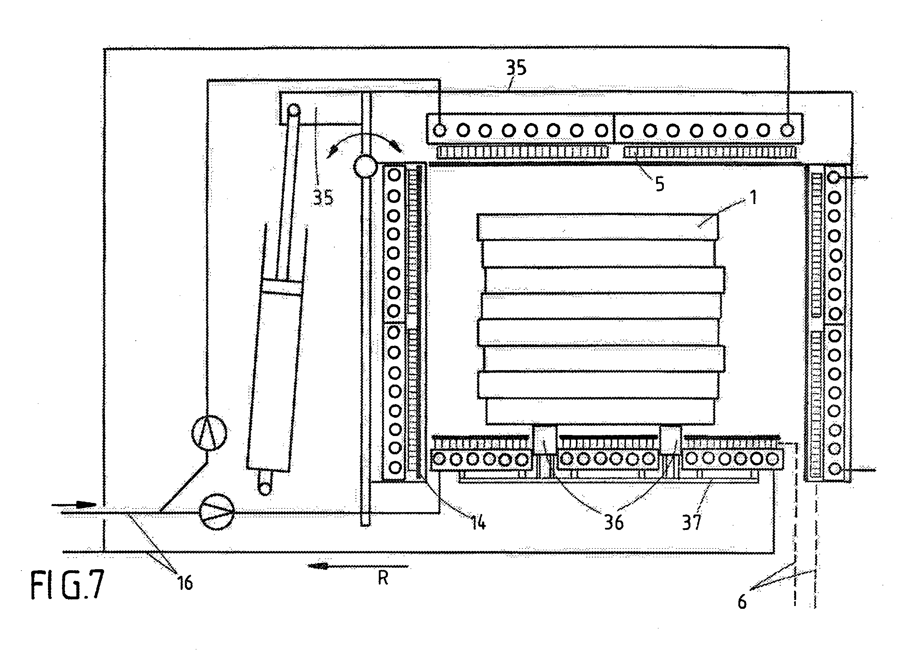

Die Figur 7 zeigt in einer geschnittenen Seitenansicht einen Speicherplatz 28 im erwähnten Brammenlager 26. Hier kann eine Bramme 1 individuell oder - wie dargestellt - ein Brammenstapel gespeichert werden. Auf der Oberseite ist eine schwenkbare oder verfahrbare Haube 35 angebracht, die das Brammenhandling ermöglicht. Der Brammenstapel ist umgeben von TEG-Modulen 5. Optional können auch nur TEG-Module auf der Unterseite angeordnet und darüber eine Wärmehaube gestülpt sein. Die von den Brammen 1 abgestrahlte Energie wird wie bereits beschrieben an die TEG-Module 5 zur Stromerzeugung abgegeben. Die Kühlwassertransportrichtung ist mit R bezeichnet. Der Brammenstapel liegt auf Tragschienen 36 auf, die wiederum auf einer Grundplatte 37 angeordnet sind.

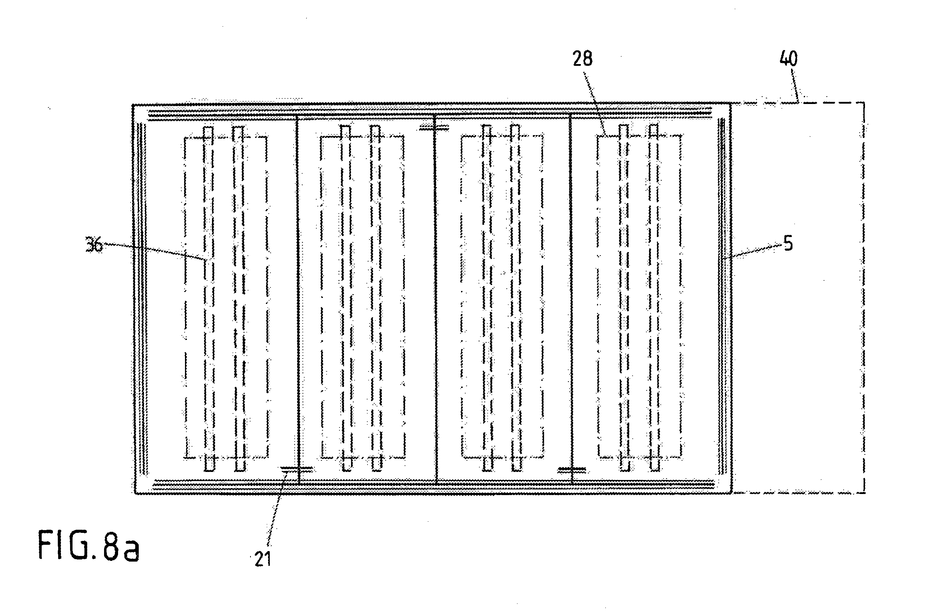

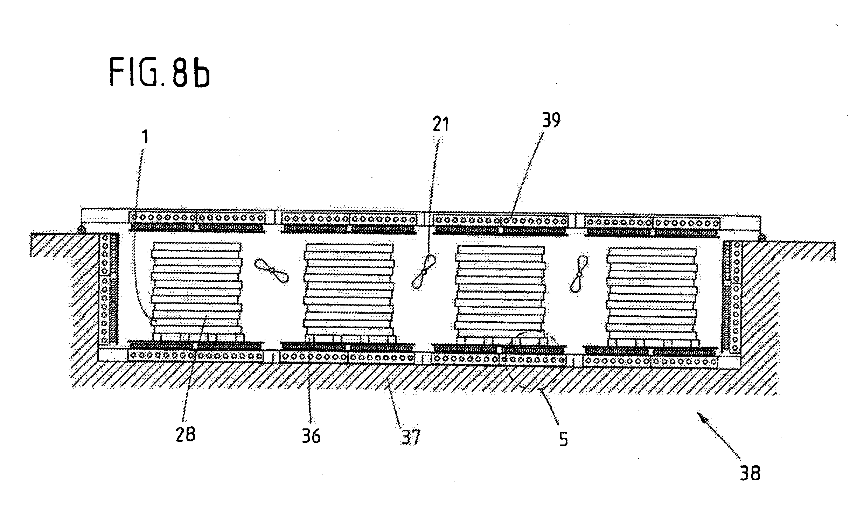

Ein typisches bevorzugtes Ausführungsbeispiel für die Anordnung mehrerer Speicherplätze nebeneinander ist in Form einer Warmhaltegrube 38 in Figur 8a in der Draufsicht und Figur 8b in der Seitenansicht dargestellt. Die Brammen 1 liegen in Längsrichtung auf Tragschienen 36 auf. Durch verschiebbare Deckenplatten 39 können die Brammen 1 hier einzeln entnommen werden. Der Ausweichplatz für die verschiebbare Haube 35 ist mit 40 bezeichnet. Alternativ sind die Deckenplatten 39 auch einzeln hochschwenkbar. Am Boden, an der Wand und optional auch an der Decke sind TEG-Module 5 angeordnet (siehe Fig. 8b). Zusätzlich können auch zwischen den Brammenstapeln TEG-Module 5 angeordnet sein (nicht dargestellt), die von beiden Seiten angestrahlt werden und in der Mittel den Kühler haben. Statt über erzwungene Konvektion die Energie an die Umgebung abzuleiten, wird sie an die TEG-Module 5 abgegeben. Die Verbindungsleitungen zu der Kühlanlage und Stromerzeugungsanlage sind nicht dargestellt.

Um den konvektiven Wärmeübergang abhängig vom Material, von der Brammenstapelhöhe und vom Temperaturniveau zu beeinflussen, wird hier mit temperaturbeständigen Ventilatoren 21 eine Luftströmung innerhalb der Grube 38 erzeugt. Hiermit kann gleichzeitig die Abkühlgeschwindigkeit und Temperaturverteilung in der Grube beeinflusst werden. Soll der Wärmeübergang von den Brammen 1 zu den TEG-Modulen 5 reduziert werden, d. h. es ist bei z. B. bestimmten Brammenmaterialien eine extrem niedrigere Abkühlgeschwindigkeit erwünscht, so ist auch ein teilweises Zustellen bzw. Verkleiden der TEG-Module 5 durch z. B. nicht dargestellte Keramikplatten etc. definierter Stärke vorgesehen.

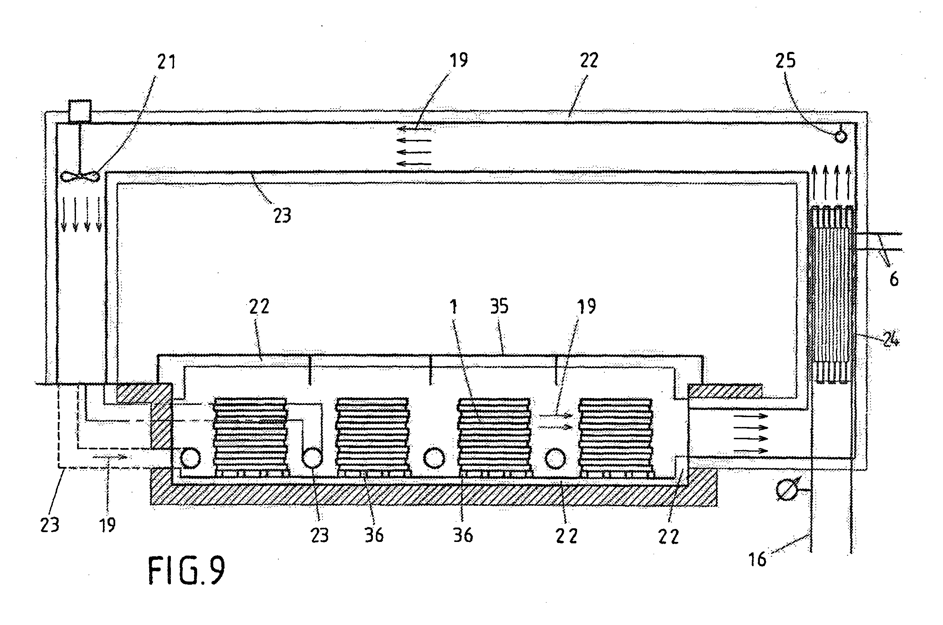

Statt TEG-Module 5 um die Brammenstapel anzuordnen, können die Brammen 1 in einem isolierten Raum (z. B. Warmhaltegrube) gelagert werden, durch den über eine Ringleitung ein gasförmiges Medium (z. B. Luft) strömt, wie es in dem Ausführungsbeispiel in Fig. 9 dargestellt ist. Hier wird mit Hilfe eines Gebläses 21 eine Zwangsströmung durch den Brammenspeicherraum über den Wärmetauscherkanal 23 bzw. mehrerer kleiner Rohrkanäle und zurück erzeugt. Alternativ kann auch für Sonderfälle die Abluft in einem Kamin mit Wärmetauscher abgeleitet werden. Die Ringleitung vermeidet jedoch Abluft-Wärmeverluste. In der Ringleitung gibt z. B. die Luft 19 die Wärmeenergie an TEG-Modul-Einheit bzw. Wärmetauschereinheit 24 (umfassend den Heißluftkanal, das TEG-Modul 5 und Kühlkanäle für die Wasserkühlung, vorzugsweise schichtweise aufgebaut) ab.

Der Brammenspeicherraum kann in Form einer Warmhaltegrube ausgebildet oder auf ebener Erde angeordnet sein. Es können, wie in Fig. 9 dargestellt, mehrere Brammenstapel oder auch einzelne Brammenstapel - im Sonderfall einzelne Brammen 1 - in einem Raum angeordnet sein, durch den jeweils separat in einer Ringleitung ein gasförmiges Medium 19 (z. B. Luft, Rauchgas, Stickstoff) durchgeblasen wird.

Um den konvektiven Wärmeübergang von der Bramme 1 bzw. Brammenstapel an die Luft 19 zu erhöhen, können Strahlungsbleche (nicht dargestellt) neben den Stapeln oder als Wandverkleidung montiert sein. Die Strahlungsbleche nehmen die Strahlungsenergie der Brammen auf, erwärmen sich und vergrößern die Wärmetauscherfläche für den konvektiven Wärmeübergang an das zirkulierende gasförmige Medium 19 (z. B. Luft) und steigern so die Effizienz.

Besonders vorteilhaft, kann mit dem Gebläse 21 als Stellglied die Abkühlgeschwindigkeit der Brammen gesteuert werden. Weiterhin ist eine Anpassung der Gebläseleistung in Abhängigkeit der Brammentemperatur möglich. Zusätzlich kann die Temperatur des gasförmigen Mediums 19 hinter den TEG-Modulen 5 abhängig von den Bedingungen bzw. Grenzen der TEG-Anlage oder anderer Zielvorgaben eingestellt werden.

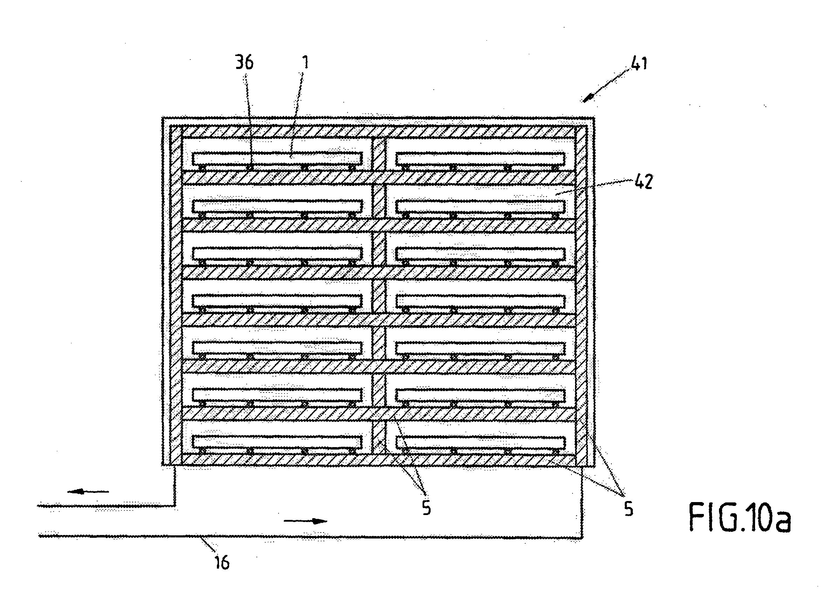

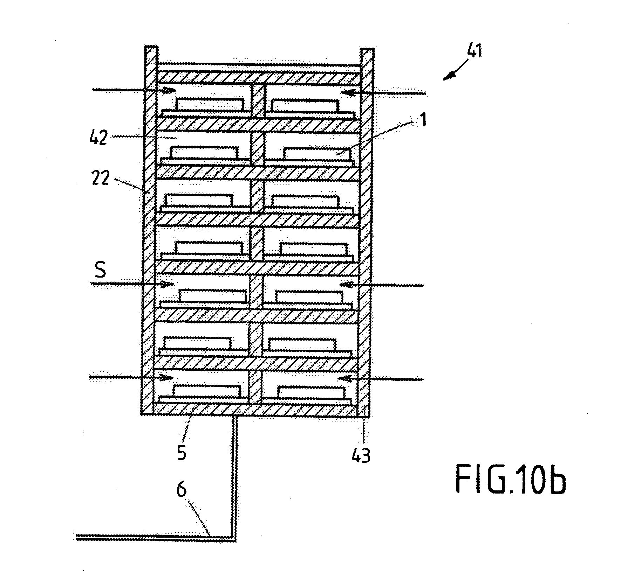

In den Figuren 10a und 10b sind in einer geschnitten Vorderansicht und einer geschnitten Seitenansicht ein Brammen-Hochregallager 41 dargestellt, in dem eine möglichst kompakte und kostengünstige Speicherung durchführbar ist. Die Brammen 1 werden flach seitlich in Füllrichtung S in die Speicherplätze 42 beispielsweise mit einem (nicht eingezeichneten) Stapler eingeschoben, wozu das Brammen-Hochregallager mit abschnittsweise verfahrbaren seitlichen Türen 43 ausgebildet ist. Innerhalb des Brammen-Hochregallagers 41 liegen die Brammen 1 auf Tragschienen 36 auf. In bzw. vor den Wänden und Decken sind TEG-Module 5 integriert, damit sich die tragenden Teile der Konstruktion nicht zu stark aufheizen und so die Standfestigkeit erhalten bleibt. Im mittleren Bereich können zwischen den Brammen (Mittenwände) TEG-Module beidseitig um ein Kühlsystem angeordnet sein. D.h. die Innenwände können schichtweise aus der Kombination von Wärmetauscherplatte / TEG-Modul / Kühlung / TEG-Modul / Wärmetauscherplatte aufgebaut sein. Details zu den TEG-Modulen etc. sind auf den Fig. 10 a, b nicht zu sehen.

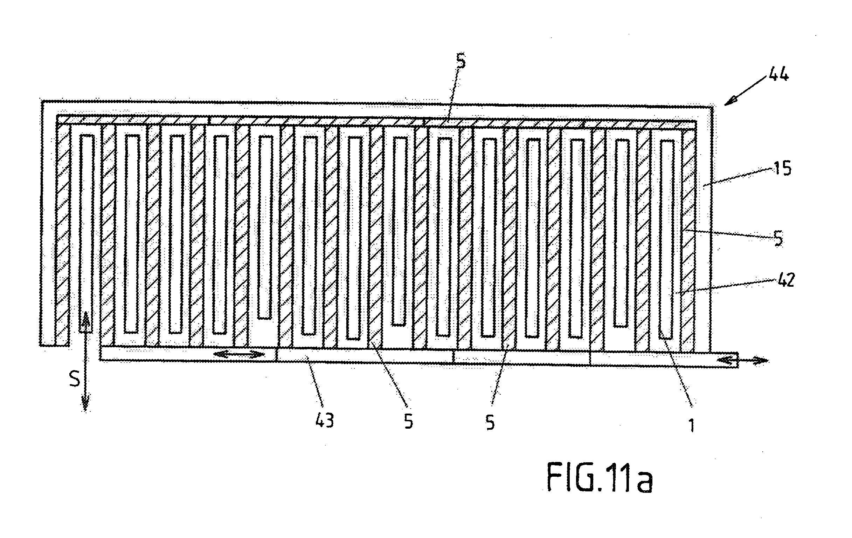

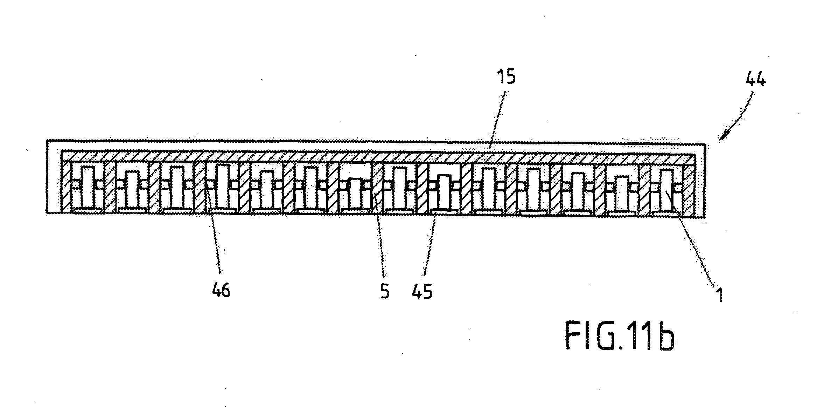

Eine alternative Möglichkeit der Brammenlagerung besteht darin, die Brammen 1 in Speicherplätze eines Hochkant-Brammenlagers 44 zu lagern. In der Figur 11 a ist ein derartiges Hochkantregal in der Draufsicht und in der Figur 11 b in einer geschnittenen Vorderansicht dargestellt. Zur Lagerung werden die Brammen 1 gekippt, auf ihre Breitseite gestellt und dann hochkant von der Seite in die Speicherplätze 42 des Hochkant-Brammenlagers 44 geschoben. Die Füllrichtung S ist in Figur 11a mit einem Pfeil angegeben. Durch die größere Packungsdichte der Hochkantlagerung mit zwischen den Brammen 1 angeordneten TEG-Modulen 5 findet ein intensiver Wärmeübergang von den Brammen 1 auf die TEG-Module 5 statt. Um Energieverlusten zu begegnen, ist eine verfahrbare wärmeisolierte Tür 43 vorhanden, die bei Bedarf in Transportrichtung verschoben werden kann. Die hochkant gestellten Brammen 1 ruhen beispielsweise auf Rollen 45 oder anderweitig ausgebildeten Auflagen, durch die ein seitliches Ein- und Ausbringen der Brammen in das Hochkant-Brammenlager 44 erleichtert wird. Zur seitlichen Führung und Kippsicherung der Brammen sind neben den TEG-Modulen 5 seitlich Abstützungen 46, beispielsweise auch hier Rollen angeordnet, durch die gleichfalls eine leichtere Verschiebung des Ein- und Ausbringens der Brammen 1 ermöglicht wird. Die TEG-Module 5 mit entsprechender Kühlung 15 und Verkabelung bzw. Verrohrung sind hier nur schematisch dargestellt und analog zuvor gezeigten Ausführungsformen angeordnet.

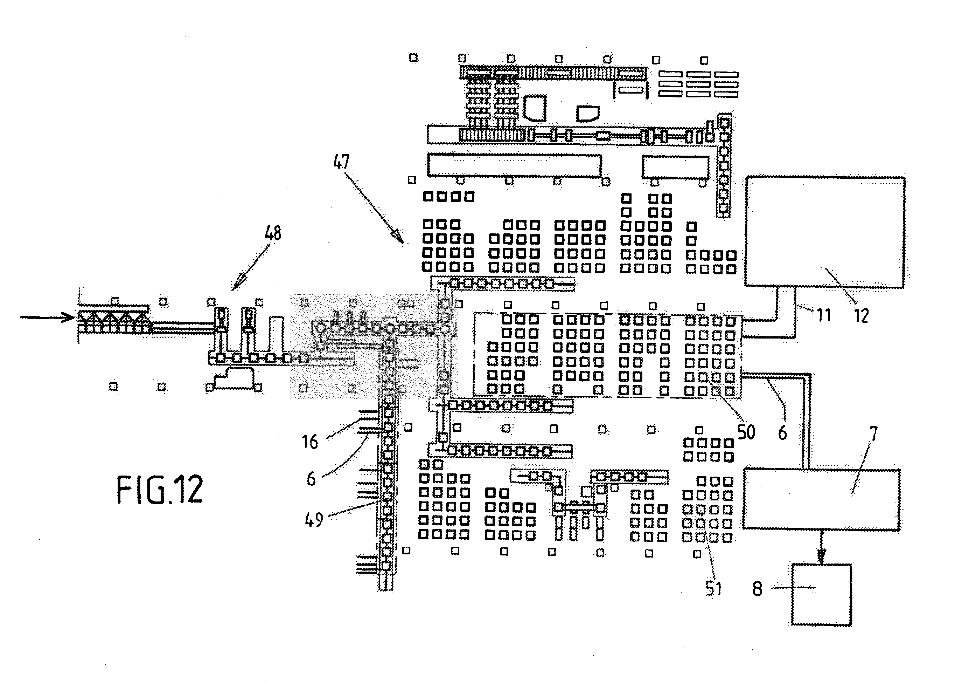

In Figur 12 ist ein Coillager 47 in der Draufsicht dargestellt. Die von einem Haspel 48 erzeugten Coils gelangen über eine Coil-Transportlinie 49, die beispiels- weise mit TEG-Modulen umgeben ist oder mit Wärmedämmhauben ausgebildet sein kann, zu ihren Lagerplätzen. Teilweise sind diese Lagerplätze als Speicherplätze mit TEG-Modulen 50 ausgebildet, der übrige Rest sind übliche Coil-Lagerplätze ohne TEG-Module 51. Je nach der noch vorhandenen Temperatur und dem Kühlfortschritt der Coils findet ein durch das Prozessmodell gesteuerter Austausch der Coils zwischen den Lagerplätzen und den Speicherplätzen statt. Die in den Speicherplätzen angebrachten TEG-Module sind hier nicht dargestellt.

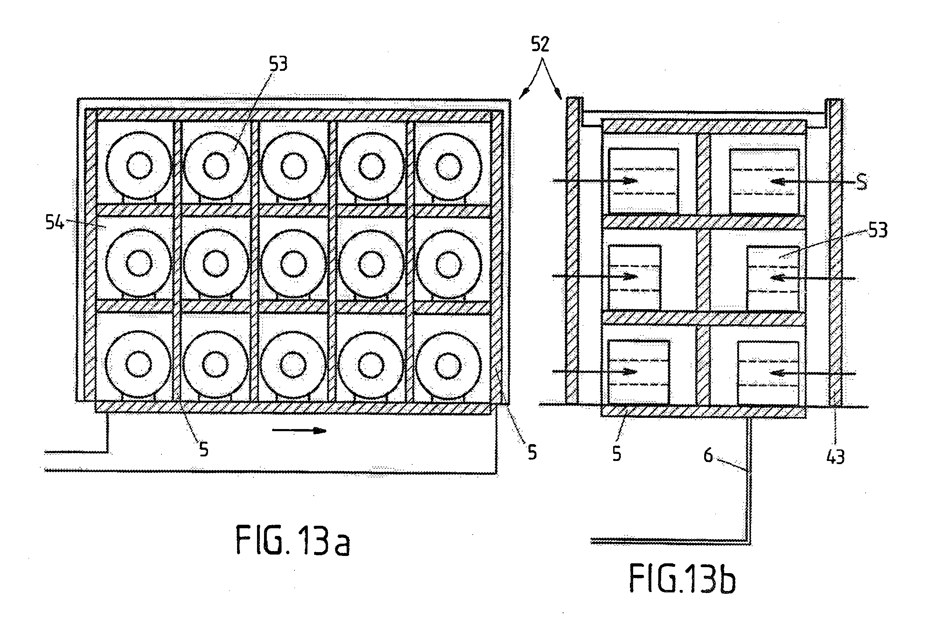

In etwa gleicher Weise wie die Brammen im Ausführungsbeispiel der Figuren 10a und 10b können auch Coils zu ihrer Abkühlung und Stromgewinnung in einem Coil-Hochregallager 52 gelagert werden, wie es in den Figuren 13a in einer geschnittenen Vorderansicht und 13b in einer geschnittenen Seitenansicht dargestellt ist. Das gezeigte Coil-Hochregallager 52 unterscheidet sich in konstruktiver Hinsicht nicht vom Brammen-Hochregallager, so dass die hier entsprechenden Bezugszeichen auf das Coil-Hochregallager 52 übertragbar sind, wobei die Coils mit 53 bezeichnet sind. Gegenüber dem Brammen-Hochregallager bestehen beim Coil-Hochregallager 52 die Optionen, dass die dargestellten Coilfächer 54 aus Stabilitätsgründen auch seitlich gegeneinander versetzt angeordnet sein können und neben einer rechteckigen auch beispielsweise eine sechseckige Ausbildung der Coilfächer 54 möglich ist. Auch hier sind die Böden, Wände und Decken bestehend aus der tragenden Konstruktion und den TEG-Modulen nur schematisch dargestellt.

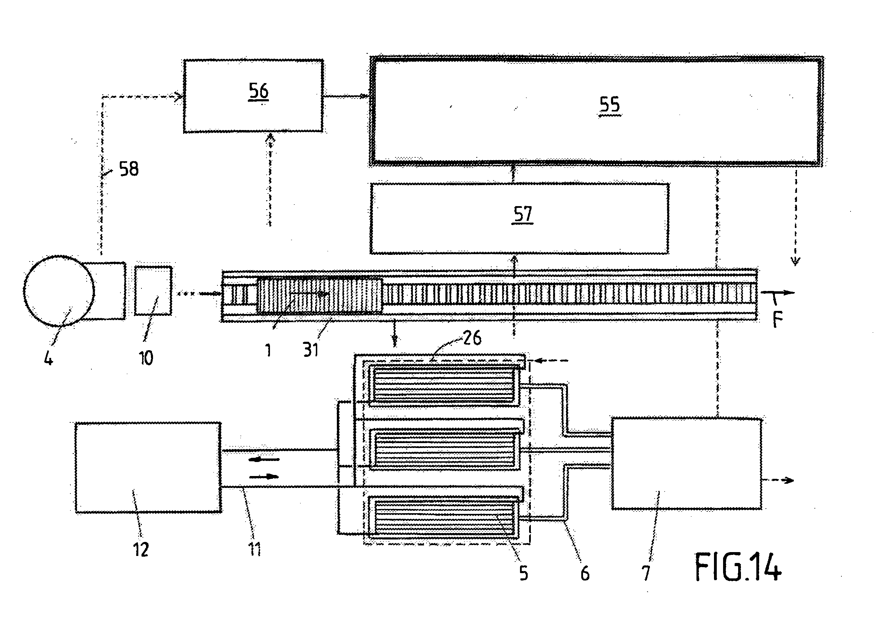

Ein Prozessmodell zur Steuerung des gesamten Prozesses der Umwandlung der Restwärme innerhalb der Stranggießanlage und von Brammen 1 bzw. Coils 53 in elektrische Energie einschließlich des erforderlichen Brammenhandlings ist in Figur 14 am Beispiel der Abkühlung von Brammen 1 dargestellt. Auf einem Rollgang 31 werden warme Brammen 1 von der Stranggießanlage 4 bzw. Brennschneidanlage 10 zum Brammenlager 26 transportiert und dort auf Speicherplätzen mit TEG-Modulen (entsprechend z. B. Fig. 7) abgelegt. Nach durchgeführter Kühlung werden die abgekühlten Brammen 1 dann dem Brammenlager 26 entnommen und auf andere Brammenlagerplätze ohne TEG-Module gelegt oder in Transportrichtung F zur Walzstraße gefördert. Der erzeugte Strom wird zu den Spannungswandlern 7 geführt und in das Stromnetz eingespeist.

Über entsprechende Signalleitungen 58 werden dem Prozessmodell 55 die Brammen-Informationen 56 (Brammen-Input) sowie die Informationen betreffend die Speicherplätze bzw. TEG-Modulplätze 57 (Speicherplatz-Input) zugeführt:

Brammen-Input: Brammentonnage, Brammengeometrie, Brammentemperatur (gemessen, gerechnet), Gießgeschwindigkeit,

Speicherplatz-Input: gemessene Ein- und Auslauftemperatur des Kühlmediums des TEG-Moduls für jeden Speicherplatz.

Aus diesen Informationen werden im Prozessmodell 55 Verfahrensparameter berechnet und über entsprechende Steuerleitungen zur Steuerung des Brammenhandlings verwendet. Im Einzelnen werden folgende Berechnungen durchgeführt:

- Berechnung der Brammentemperaturen und Kombination mit dem Brammensortier- und Lagersystem.

- Optimierung der Brammen-Austragetemperatur in Abhängigkeit der Speicherplätze.

- Errechnung der Temperatur der Brammen in den Speicherplätzen.

- Pumpenkapazität bzw. Einstellung der Schaltventile für jeden TEG-Speicherplatz mit TEG-Kühlung in Abhängigkeit der Brammentemperatur und abhängig davon, ob eine Bramme auf dem Speicherplatz liegt.

- Berechnung des Gesamtwärmestroms und erzeugter Strommenge.

- Vorgabe der Gießgeschwindigkeit in der Stranggießanlage.

- Bestimmung des Austragezeitpunktes der Brammen aus den Speicherplätzen.

Bezugszeichenliste:

| 1 | Bramme / Knüppel / Gießstrang / Coil (Produkt) / Block / Träger / Rundstahl |
| 2 | Thermoelement (thermoelektrischer Generator - TEG) |
| 3 | Wasserkühlung |
| 4 | Stranggießanlage |
| 5 | TEG-Modul |
| 6 | Kabel |
| 7 | Spannungswandler / Wechselrichter |
| 8 | Netz |
| 9 | Rollgangsabdeckung |
| 10 | Brennschneidanlage |
| 11 | Kühlwasserleitung |
| 12 | Kühlung |
| 13 | Segmentrolle |
| 14 | Wärmetauscherplatte bzw. Schutzplatte |
| 15 | Kühlung |
| 16 | Kühlleitung |
| 17 | Kühlrippe |
| 18 | Wärmetauscher |
| 19 | Gas (Luft / Stickstoff / Rauchgas) |
| 20 | Rippe |
| 21 | Gebläse / Ventilator |
| 22 | Wärmeisolierung |
| 23 | Wärmetauscherkanal |
| 24 | Wärmetauschereinheit |
| 25 | Temperaturfühler |
| 26 | Brammenlager |
| 27 | Zuführrollgang |
| 28 | Speicherplatz mit TEG-Modul |
| 29 | Lagerplatz |
| 30 | Wärmeofen |
| 31 | Rollgang |
| 32 | Rollgangsrolle |
| 33 | Halteeinrichtung für die Stromerzeugungseinheit |
| 34 | Strahlungswärme und Konvektion |
| 35 | Haube (schwenkbar, verfahrbar) |
| 36 | Tragschiene |
| 37 | Grundplatte |
| 38 | Warmhaltegrube |
| 39 | Deckenplatte |
| 40 | Ausweichplatz |
| 41 | Brammen-Hochregallager |

| 42 | Speicherplatz |
| 43 | Tür (verfahrbar, wärmeisoliert) |
| 44 | Hochkant-Brammenlager |
| 45 | Rolle |
| 46 | Abstützung |
| 47 | Coillager |
| 48 | Haspel |
| 49 | Coil-Transportlinie |
| 50 | Coil-Lagerplatz mit TEG-Modul |
| 51 | Coil-Lagerplatz ohne TEG-Modul |
| 52 | Coil-Hochregallager |
| 53 | Coil |
| 54 | Coilfach |
| 55 | Prozessmodell |
| 56 | Brammen-Information |
| 57 | Speicherplatzinformation |
| 58 | Signal- oder Steuerleitung |
| 59 | Abgaskanal des Wärmeofens |
| dQ/dt | Wärmestrom |
| $T_1$ | Temperatur |
| $T_2$ | Temperatur |
| F | Transportrichtung |
| R | Kühlwassertransportrichtung |
| S | Füllrichtung |

**Patentansprüche**

1. Verfahren zur Energierückgewinnung in hüttentechnischen Anlagen umfassend eine Stranggießanlage (4) und/oder einen Ofen und/oder eine Warmbandstraße und/oder mindestens ein Transportweg zwischen den Anlagenteilen und/oder ein Brammenlager und/oder ein Coillager durch Nutzung von Restwärme eines Anlagenteils und/oder warmen Produkts (1),
**dadurch gekennzeichnet, dass**
ein Wärmestrom (dQ/dt) von einem Anlagenteil und/oder warmen Produkt (1) mit einem ersten Temperaturniveau ($T_1$) zu einem Ort mit einem zweiten, geringeren Temperaturniveau ($T_2$) fließen gelassen wird, wobei im Bereich zwischen den beiden Temperaturniveaus ($T_1$, $T_2$) mindestens ein Thermoelement (2) angeordnet wird, mit dem unter Nutzung des Wärmestroms (dQ/dt) unmittelbar elektrische Energie gewonnen wird.

2. Verfahren nach Anspruch 1, **dadurch gekennzeichnet, dass** als Thermoelement (2) ein solches mit mindestens einer dotierten Halbleiterpaarung eingesetzt wird.

3. Verfahren nach Anspruch 1 oder 2, **dadurch gekennzeichnet, dass** als Thermoelement (2) ein solches verwendet wird, das mittels des PVD-Verfahrens (Physical Vapor Deposition) beschichtet und anschließend mechanisch hergestellt wurde.

4. Verfahren nach einem der Ansprüche 1 bis 3, **dadurch gekennzeichnet, dass** das mindestens eine Thermoelement (2) in einem Temperaturbereich von 100 °C - 120 °C eingesetzt wird und das Material des Thermoelements (2) an die jeweilige Temperatur angepasst ist.

5. Verfahren nach einem der Ansprüche 1 bis 4, **dadurch gekennzeichnet, dass** eine Anzahl von Thermoelementen (2) verwendet wird, die zu einem thermoelektrischen Generator (TEG) zusammengeschaltet ist.

6. Verfahren nach einem der Ansprüche 1 bis 5, **dadurch gekennzeichnet, dass** zunächst eine Bramme (1) in einer Stranggießanlage (4) stranggegossen wird und dass hinter der Stranggießanlage (4) die Bramme (1) mittels einer Trennvorrichtung (10), insbesondere einer Brennschneidmaschine, abgelängt wird, wobei die Bramme (1) vor und/oder hinter der Trennvorrichtung (10) mit Wärmedämmmitteln gegen Wärmeabfuhr geschützt wird.

7. Verfahren nach Anspruch 6, **dadurch gekennzeichnet, dass** das als Wärmedämmhaube ausgebildete Wärmedämmmittel (35) an die aktuelle Brammengröße und/oder den Gegebenheiten beim Ablängen der Bramme (1) angepasst positioniert wird.

8. Verfahren nach Anspruch 6 oder 7, **dadurch gekennzeichnet, dass** die abgelängte Bramme (1) in ein Brammenlager (26) in Längs- oder Querrichtung transportiert wird, wobei der Transport über einen Rollgang erfolgt, der zumindest teilweise von Thermoelementen (2) bzw. thermoelektrischen Generatoren umgeben ist.

9. Verfahren nach Anspruch 8, **dadurch gekennzeichnet, dass** die Bramme (1) beim Transport zwischen der Stranggießanlage (4) und dem Brammenlager (26) so abkühlt, dass sie eine vorgegebene Temperatur erreicht oder nicht unterschreitet.

10. Verfahren nach einem der Ansprüche 1 bis 9, **dadurch gekennzeichnet, dass** das mindestens eine Thermoelement (2) an zumindest einer Seite gekühlt wird.

11. Verfahren nach einem der Ansprüche 1 bis 10, **dadurch gekennzeichnet, dass** Restwärme des warmen Produkts (1), die nicht mittels des Thermoelements (2) in elektrische Energie umgewandelt wird, für einen anderen Prozess eingesetzt wird, der Wärme benötigt.

12. Verfahren nach einem der Ansprüche 1 bis 11, **dadurch gekennzeichnet, dass** das Verfahren zur Stromgewinnung mit Thermoelementen und/oder mit thermoelektrischen Generator mit anderen Energierückgewinnungstechnologien, vorzugsweise Kreisprozessen, insbesondere ORC-Anlage/Kalina-Anlage, zur weiteren Stromgewinnung kombiniert wird.

13. Hüttentechnische Anlage umfassend eine Stranggießanlage (4) und/oder einen Ofen und/oder eine Warmbandstraße und/oder mindestens ein Transportweg zwischen den Anlagenteilen und/oder ein Brammenlager und/oder ein Coillager, die einen Anlagenteil und/oder ein warmes Produkt (1) mit einem ersten Temperaturniveau ($T_1$) sowie einen Ort mit einem zweiten, geringeren Temperaturniveau ($T_2$) aufweist,
**dadurch gekennzeichnet, dass**
im Bereich zwischen dem Anlagenteil und/oder dem warmen Produkt (1) mit dem ersten Temperaturniveau ($T_1$) und dem Ort mit dem zweiten Temperaturniveau ($T_2$) mindestens ein Thermoelement (2) angeordnet ist, das zur direkten Erzeugung elektrischer Energie unter Nutzung des sich aufgrund des Temperaturgradienten ergebenden Wärmestroms (dQ/dt) geeignet ist.

14. Anlage nach Anspruch 13, **dadurch gekennzeichnet, dass** das Thermoelement (2) mindestens eine dotierte Halbleiterpaarung aufweist.

15. Anlage nach Anspruch 13 oder 14, **dadurch gekennzeichnet, dass** das Thermoelement (2) mittels des PVD-Verfahrens (Physical Vapor Deposition) hergestellt ist.

16. Anlage nach einem der Ansprüche 13 bis 15, **dadurch gekennzeichnet, dass** eine Anzahl von Thermoelementen (2) zu einem thermoelektrischen Generator (TEG) (5) zusammengeschaltet ist.

17. Anlage nach einem der Ansprüche 13 bis 16, **dadurch gekennzeichnet, dass** zwischen und/oder neben den Strangrollen der Stranggießanlage oder neben der Stranggießanlage Thermoelemente und/oder thermoelektrische Generatoren angeordnet sind.

18. Anlage nach einem der Ansprüche 13 bis 17, **dadurch gekennzeichnet, dass** sie einen Ofen (30) umfasst, der innerhalb des Abgaskanals (59) oder/und an den Rohr- bzw. Kanalwandungen Thermogeneratormodule aufweist.

19. Anlage nach einem der Ansprüche 13 bis 18, **dadurch gekennzeichnet, dass** ein Transportweg, insbesondere ein Rollgang, an dem kein Thermoelement (2) angeordnet ist, mit Wärmedämmmitteln versehen ist.

20. Anlage nach einem der Ansprüche 13 bis 19, **dadurch gekennzeichnet, dass** Thermoelemente oder thermoelektrische Generatoren angeordnet sind, die das transportierte warme Produkt insbesondere. Bramme, Knüppel oder Coil, innerhalb eines Transportweges, insbesondere eines Rollengangs, bzw. in der Stranggießanlage, im Ofen und/oder in der Warmbandstraße, umgeben.

21. Anlage nach einem der Ansprüche 13 bis 20, **dadurch gekennzeichnet, dass** sie ein Brammenlager (26) und/oder Coillager (47) umfasst, dessen Wandungen Thermoelemente (2) und/oder Wärmedämmmittel aufweisen.

22. Anlage nach Anspruch 21, **dadurch gekennzeichnet, dass** die Thermoelemente (2) und/oder die Wärmedämmmittel beweglich, insbesondere schwenkbar oder translatorisch verschiebbar angeordnet sind.

23. Anlage nach Anspruch 21 oder 22, **dadurch gekennzeichnet, dass** in dem Brammen- oder Coillager Luftumwälzmittel (21), insbesondere mindestens ein Gebläse, angeordnet sind.

24. Anlage nach einem der Ansprüche 21 bis 23, **dadurch gekennzeichnet, dass** eine Ringleitung als Gastransportleitung angeordnet ist, und ein Gebläse, mit Hilfe dessen von dem in der Stranggießanlage (4), im Ofen und/oder in der Warmbandstraße befindlichen warmen Produkt (1) angeordneten gasförmigen Wärmetransportmedium, insbesondere Luft, Rauchgas, Stickstoff, die Energie zu einer Wärmetauschereinheit (24) und/oder zu den thermoelektrischen Generatoren transportiert und dort konzentriert übertragbar ist.

25. Anlage nach Anspruch 23 oder 24, **dadurch gekennzeichnet, dass** mit Hilfe des Gebläses der Durchsatz des gasförmigen Wärmetransportmediums und damit der Energieaustausch regelbar ist.

26. Anlage nach einem der Ansprüche 21 bis 25, **dadurch gekennzeichnet, dass** das Brammen- oder Coillager als Warmhaltegrube oder Hochregallager oder auf Hüttenflur ausgebildet ist.

27. Anlage nach einem der Ansprüche 13 bis 26, **dadurch gekennzeichnet, dass** Kühlmittel angeordnet sind, um mindestens eine Seite des Thermoelements (2) zu kühlen.

28. Anlage nach einem der Ansprüche 13 bis 27, **dadurch gekennzeichnet, dass** mehrere thermoelektrischen Generatoren in einer Wärmetauschereinheit (24) gestapelt angeordnet sind.

29. Anlage nach Anspruch 27 oder 28, **dadurch gekennzeichnet, dass** die Kühlmittel zum Betrieb mit Luft, Stickstoff, Rauchgas, Wasser oder einem bei hohen Temperaturen siedenden Medium, insbesondere Thermoöl, ausgebildet sind.

**Claims**

1. Method for energy recovery in metallurgical plants comprising a continuous casting plant (4) and/or a furnace and/or a hot-strip rolling train and/or at least one transport path between parts of the plant and/or a slab store and/or a coil store by utilising residual heat of a plant component and/or hot product (1), **characterised in that** a heat flow dQ/dt is allowed to flow from a plant part and/or hot product (1) having a first temperature level ($T_1$) to a location having a second, lower temperature level ($T_2$), wherein in the region between the two temperature levels $T_1$, $T_2$ at least one thermocouple element (2) is arranged by which electrical energy is directly obtained by utilising the heat flow dQ/dt.

2. Method according to claim 1, **characterised in that**, as thermocouple element (2), a thermocouple element with at least one doped semiconductor pair is used.

3. Method according to claim 1 or 2, **characterised in that**, as thermocouple element (2), a thermocouple element is used which was coated by means of the PVD (Physical Vapour Deposition) method and subsequently mechanically manufactured.

4. Method according to any one of claims 1 to 3, **characterised in that** the at least one thermocouple element (2) is utilised in a temperature range of 100° C to 120° C and the material of the thermocouple element (2) is adapted to the respective temperature.

5. Method according to any one of claims 1 to 4, **characterised in that** use is made of a number of thermocouple elements (2) which are connected together to form a thermoelectric generator (TEG).

6. Method according to any one of claims 1 to 6, **characterised in that** initially a slab (1) is continuously cast in a continuous casting plant (4) and that following the continuous casting plant (4) the slab (1) is cut to length by means of a separating device (10), particularly a torch cutting machine, wherein the slab (1) is protected against heat discharge in front of and/or behind the separating device (10) by thermal insulation means.

7.  Method according to claim 6, **characterised in that** thermal insulation means (35) constructed as a thermal insulation hood is positioned in adaptation to the current slab size and/or the conditions when cutting the slab (1) to length.

8.  Method according to claim 6 or 7, **characterised in that** the cut-to-length slab (1) is transported into a slab store (26) in longitudinal or transverse direction, wherein transport takes place by way of a roller path which is surrounded at least partly by thermocouple elements (2) or thermoelectric generators.

9.  Method according to claim 8, **characterised in that** the slab (1) is so cooled during transport between the continuous casting plant (4) and the slab store (26) that it reaches or does not drop below a predetermined temperature.

10. Method according to any one of claims 1 to 9, **characterised in that** at least one thermocouple element (2) is cooled on at least one side.

11. Method according to any one of claims 1 to 10, **characterised in that** the residual heat, which has not been converted into electrical energy by means of the thermocouple element (2), of the hot product (1) is utilised for another process which requires heat.

12. Method according to one of claims 1 to 11, **characterised in that** the method for obtaining current by thermocouple elements and/or by a thermoelectric generator is combined with other energy recovery technologies, preferably circulation processes, particularly an ORC plant / Kalina plant, for obtaining further current.

13. Metallurgical plant, comprising a continuous casting plant (4) and/or a furnace and/or a hot spring rolling train and/or at least one transport path between parts of the plant and/or a slab store and/or a coil store, comprising a plant part and/or a hot product (1) having a first temperature level ($T_1$) and a location having a second, lower temperature level ($T_2$), **characterised in that** arranged in the region between the plant part and/or the hot product (1) having the first temperature level ($T_1$) and the location with the second temperature level ($T_2$) is at least one thermocouple element (2) for direct generation of electrical energy by utilising the heat flow (dQ/dt) resulting from the temperature gradient.

14. Plant according to claim 14, **characterised in that** the thermocouple element (2) comprises at least one doped semiconductor pair.

15. Plant according to claim 14 or 15, **characterised in that** the thermocouple element (2) is manufactured by means of the PVD (Physical Vapour Deposition) method.

16. Plant according to any one of claims 13 to 15, **characterised in that** several thermocouple elements (2) are connected together to form a thermoelectric generator (TEG) (5).

17. Plant according to any one of claims 13 to 16, **characterised in that** thermocouple elements and/or thermoelectric generators are arranged between and/or adjacent to the strand rollers of the continuous casting plant or adjacent to the continuous casting plant.

18. Plant according to any one of claims 13 to 17, **characterised in that** it comprises a furnace (30) which has thermogenerator modules within the exhaust gas duct (59) or/and at the pipe or duct walls.

19. Plant according to any one of claims 13 to 18, **characterised in that** a transport path, particularly a roller path, on which no thermocouple element (2) is arranged, is provided with thermal insulating means.

20. Plant according to any one of claims 13 to 19, **characterised in that** thermoelements or thermoelectric generators, which surround the transported hot product, in particular slab, billet or coil, within a transport path, particularly a roller path or in the continuous casting plant, in the furnace and/or in the hot-strip rolling train, are arranged.

21. Plant according to any one of claims 13 to 20, **characterised in that** it comprises a slab store (26) and/or coil store (47), the walls of which have thermocouple elements (2) and/or thermal insulating means.

22. Plant according to claim 21, **characterised in that** the thermocouple elements (2) and/or the thermal insulating means are arranged to be movable, particularly pivotable or translationally slidable.

**23.** Plant according to claim 21 or 22, **characterised in that** air circulating means (21), particularly at least one blower, are arranged in the slab or coil store.

**24.** Plant according to any one to claims 21 to 23, **characterised in that** a ring line is arranged as gas transport line, and a fan, with the help of which the energy from the hot product (1) disposed in the continuous casting plant (4), in the furnace and/or in the hot-strip rolling train is transported by a gaseous heat transport medium, particularly air, flue gas or nitrogen, to a heat exchanger unit (24) and/or to the thermoelectric generators and is transferrable there in concentrated form.

**25.** Plant according to claim 23 or 24, **characterised in that** the throughput of the gaseous heat transport medium and thus the energy exchange can be regulated with the help of the fan.

**26.** Plant according to any one of claims 21 to 25, **characterised in that** the slab or coil store is constructed as a pit for keeping warm or as a high shelf store or is constructed on the mill floor.

**27.** Plant according to any one of claims 13 to 26, **characterised in that** cooling means are arranged for cooling at least one side of the thermocouple element (2).

**28.** Plant according to any one of claims 13 to 27, **characterised in that** several thermoelectric generators are arranged to be stacked in a heat exchanger unit (24).

**29.** Plant according to claim 27 or 28, **characterised in that** the cooling means are constructed for operation with air, nitrogen, flue gas, water or a medium which boils at high temperature, particularly thermoil.

### Revendications

**1.** Procédé pour la récupération d'énergie dans des installations de hauts-fourneaux comprenant une installation de coulée continue (4) et/ou un four et/ou un train de feuillard à chaud et/ou au moins une voie de transport entre les parties de l'installation et/ou un entrepôt pour les brames et/ou un entrepôt pour les bobines en utilisant la chaleur résiduelle d'une partie de l'installation et/ou du produit chaud (1), **caractérisé en ce qu'**on laisse s'écouler un courant thermique (dQ/dt) d'une partie de l'installation et/ou d'un produit chaud (1) possédant un premier niveau de température ($T_1$) à un endroit possédant un deuxième niveau de température inférieur ($T_2$), dans lequel, dans la zone située entre les deux niveaux de température ($T_1$, $T_2$), on dispose au moins un thermocouple (2) avec lequel, en utilisant le courant thermique (dQ/dt), on obtient directement de l'énergie électrique.

**2.** Procédé selon la revendication 1, **caractérisé en ce qu'**on met en oeuvre à titre de thermocouple (2) un thermocouple comprenant au moins un appariement de semi-conducteurs dopés.

**3.** Procédé selon la revendication 1 ou 2, **caractérisé en ce qu'**on utilise à titre de thermocouple (2) un thermocouple qui a été enduit au moyen du procédé PVD (dépôt physique en phase vapeur) et qui a été ensuite fabriqué par voie mécanique.

**4.** Procédé selon l'une quelconque des revendications 1 à 3, **caractérisé en ce qu'**on met en oeuvre au moins un thermocouple (2) dans une plage de températures de 100 °C à 120 °C et on adapte la matière du thermocouple (2) à la température respective.

**5.** Procédé selon l'une quelconque des revendications 1 à 4, **caractérisé en ce qu'**on utilise plusieurs thermocouples (2) qui sont raccordés de manière conjointe à un générateur thermoélectrique (TEG).

**6.** Procédé selon l'une quelconque des revendications 1 à 5, **caractérisé en ce qu'**on coule d'abord en continu une brame (1) dans une installation de coulée continue (4), et **en ce que**, derrière l'installation de coulée continue (4), on met à longueur la brame (1) au moyen d'un dispositif de séparation (10), en particulier au moyen d'une machine de découpage au chalumeau, la brame (1) étant protégée devant et/ou derrière le dispositif de séparation (10) contre le dégagement de chaleur avec des moyens d'isolation thermique.

**7.** Procédé selon la revendication 6, **caractérisé en ce que** le moyen d'isolation thermique (35) réalisé sous la forme d'un capot d'isolation thermique est disposé en étant adapté à la dimension réelle de la brame et/ou aux conditions en vigueur lors de la mise à longueur de la brame (1).

**8.** Procédé selon la revendication 6 ou 7, **caractérisé en ce que** la brame mise à longueur (1) est transportée dans un entrepôt pour les brames (26), en direction longitudinale ou en direction transversale, le transport ayant lieu via un transporteur à rouleaux qui est entouré au moins en partie par des thermocouples (2), respectivement par des générateurs thermoélectriques.

**9.** Procédé selon la revendication 8, **caractérisé en ce que** la brame (1), au cours du transport entre l'installation de coulée continue (4) et l'entrepôt pour les brames (26) est refroidie de manière telle qu'elle atteint une température prédéfinie ou qu'elle ne dépasse pas vers le bas ladite température.

**10.** Procédé selon l'une quelconque des revendications 1 à 9, **caractérisé en ce qu'**on refroidit au moins un thermocouple (2) au moins d'un côté.

**11.** Procédé selon l'une quelconque des revendications 1 à 10, **caractérisé en ce que** la chaleur résiduelle du produit chaud (1), qui n'est pas transformée en énergie électrique au moyen du thermocouple (2), est mise en oeuvre pour un autre processus qui a besoin de chaleur.

**12.** Procédé selon l'une quelconque des revendications 1 à 11, **caractérisé en ce que** le procédé pour l'obtention de courant avec des thermocouples et/ou avec un générateur thermoélectrique est combiné avec d'autres technologies de récupération d'énergie de préférence des transformations cycliques, en particulier une installation ORC/Kalina, pour obtenir une plus grande quantité de courant.

**13.** Installation de haut-fourneau comprenant une installation de coulée continue (4) et/ou un four et/ou un train de feuillard à chaud et/ou au moins une voie de transport entre les parties de l'installation et/ou un entrepôt pour les brames et/ou un entrepôt pour les bobines, qui présente une partie de l'installation et/ou un produit chaud (1) possédant un premier niveau de température ($T_1$), ainsi qu'un endroit possédant un deuxième niveau de température inférieur ($T_2$), **caractérisée en ce que**, dans la zone située entre la partie de l'installation et/ou le produit chaud (1) possédant le premier niveau de température ($T_1$), et l'endroit possédant le deuxième niveau de température inférieur ($T_2$), on dispose au moins un thermocouple (2) qui est approprié pour la génération directe d'énergie électrique en utilisant le courant thermique (dQ/dt), que l'on obtient sur base du gradient de température.

**14.** Installation selon la revendication 13, **caractérisée en ce que** le thermocouple (2) présente au moins un appariement de semi-conducteurs dopés.

**15.** Installation selon la revendication 13 ou 14, **caractérisée en ce qu'**on fabrique le thermocouple (2) au moyen du procédé PVD (dépôt physique en phase vapeur).

**16.** Installation selon l'une quelconque des revendications 13 à 15, **caractérisée en ce qu'**on raccorde plusieurs thermocouples (2) de manière conjointe à un générateur thermoélectrique (TEG) (5).

**17.** Installation selon l'une quelconque des revendications 13 à 16, **caractérisée en ce qu'**on dispose entre et/ou à côté des rouleaux de l'installation de coulée continue ou à côté de l'installation de coulée continue, des thermocouples et/ou des générateurs thermoélectriques

**18.** Installation selon l'une quelconque des revendications 13 à 17, **caractérisée en ce qu'**elle comprend un four (30) qui présente à l'intérieur du canal d'échappement des gaz (59) et/ou contre les parois du tube, respectivement du canal, des modules de générateurs thermiques.

**19.** Installation selon l'une quelconque des revendications 13 à 18, **caractérisée en ce qu'**on munit de moyens d'isolation thermique une voie de transport, en particulier un transporteur à rouleaux, contre laquelle aucun thermocouple (2) n'est disposé.

**20.** Installation selon l'une quelconque des revendications 13 à 19, **caractérisée en ce qu'**on dispose des thermocouples ou des générateurs thermoélectriques qui entourent le produit chaud transporté, en particulier la brame, la billette ou la bobine, au sein d'une voie de transport, en particulier d'un transporteur à rouleaux, respectivement dans l'installation de coulée continue, dans le four et/ou dans le train de feuillard à chaud.

21. Installation selon l'une quelconque des revendications 13 à 20, **caractérisée en ce qu'**elle comprend un entrepôt pour les brames (26) et/ou un entrepôt pour les bobines (47) dont les parois présentent des thermocouples (2) et/ou des moyens d'isolation thermique.

22. Installation selon la revendication 21, **caractérisée en ce que** les thermocouples (2) et/ou les moyens d'isolation thermique sont disposés en mobilité, en particulier en pivotement ou en déplacement par translation.

23. Installation selon la revendication 21 ou 22, **caractérisée en ce que**, dans l'entrepôt pour les brames ou pour les bobines, on dispose des moyens de circulation d'air (21), en particulier au moins une soufflerie.

24. Installation selon l'une quelconque des revendications 21 à 23, **caractérisée en ce qu'**on dispose un conduit annulaire, à titre de conduit de transport de gaz, et une soufflerie à l'aide de laquelle à partir du produit chaud (1) se trouvant dans l'installation de coulée continue (4), dans le four et/ou dans le train de feuillard à chaud, à l'aide du milieu de transport de chaleur sous forme gazeuse, en particulier de l'air, du gaz de fumée, de l'azote, on transporte l'énergie en direction d'une unité d'échange de chaleur (24) et/ou en direction des générateurs thermoélectriques pour pouvoir l'y concentrer par transformation.

25. Installation selon la revendication 23 ou 24, **caractérisée en ce qu'**on peut régler le débit du milieu de transport de chaleur sous forme gazeuse et par conséquent l'échange d'énergie à l'aide de la soufflerie.

26. Installation selon l'une quelconque des revendications 21 à 25, **caractérisée en ce que** l'entrepôt pour les brames ou pour les bobines est réalisé sous la forme d'un caniveau pour le maintien de la chaleur ou d'un entrepôt à chambres très hautes ou sur le sol du haut-fourneau.

27. Installation selon l'une quelconque des revendications 13 à 26, **caractérisée en ce qu'**on dispose des moyens de refroidissement pour refroidir au moins un côté du thermocouple (2).

28. Installation selon l'une quelconque des revendications 13 à 27, **caractérisée en ce qu'**on dispose en superposition plusieurs générateurs thermoélectriques dans une unité d'échange chaleur (24).

29. Installation selon la revendication 27 ou 28, **caractérisée en ce que** les moyens de refroidissement sont réalisés pour un entraînement avec de l'air, de l'azote, du gaz de fumée, de l'eau ou un milieu possédant un point d'ébullition élevé, en particulier de l'huile thermique.

$T_2$

3

2

$\dfrac{dQ}{dt}$

$T_1$

1

FIG.1

FIG.2

FIG. 3a

FIG.3b

EP 2 494 272 B1

FIG.4a

FIG. 4b

FIG.5

EP 2 494 272 B1

FIG.6

FIG.7

EP 2 494 272 B1

FIG.8a

EP 2 494 272 B1

FIG.8b

FIG.9

EP 2 494 272 B1

FIG.10a

FIG.10b

FIG.11a

EP 2 494 272 B1

EP 2 494 272 B1

FIG.11b

FIG.12

FIG.13b

53

5

43

6

5

52

5

FIG.13a

53

5

54

FIG.14

EP 2 494 272 B1

**EP 2 494 272 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2008075870 A1
- EP 0044957 B1
- DE 2622722 C3
- EP 0027787 B1
- EP 1965446 A1
- WO 2005104156 A2